(19) Europäisches Patentamt / European Patent Office / Office européen des brevets

(11) **EP 2 316 897 A1**

(12) **EUROPEAN PATENT APPLICATION**
published in accordance with Art. 153(4) EPC

(43) Date of publication:
**04.05.2011 Bulletin 2011/18**

(21) Application number: **09808103.7**

(22) Date of filing: **04.03.2009**

(51) Int Cl.:
***C09J 7/02*** *(2006.01)*
***B32B 27/38*** *(2006.01)*
***C09J 11/04*** *(2006.01)*
***C09J 11/08*** *(2006.01)*
***C09J 163/00*** *(2006.01)*
***C09J 171/10*** *(2006.01)*
***H01B 3/00*** *(2006.01)*

(86) International application number:
**PCT/JP2009/054069**

(87) International publication number:
**WO 2010/021167 (25.02.2010 Gazette 2010/08)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **18.08.2008 JP 2008209914**

(71) Applicant: **Sekisui Chemical Co., Ltd.**
**Osaka 530-8565 (JP)**

(72) Inventors:
- **MAENAKA, Hiroshi**
  **Mishima-gun**
  **Osaka 618-8589 (JP)**
- **AOYAMA, Takuji**
  **Mishima-gun**
  **Osaka 618-8589 (JP)**
- **KUSAKA, Yasunari**
  **Mishima-gun**
  **Osaka 618-8589 (JP)**
- **HIGUCHI, Isao**
  **Mishima-gun**
  **Osaka 618-8589 (JP)**
- **WATANABE, Takashi**
  **Mishima-gun**
  **Osaka 618-8589 (JP)**
- **TAKAHASHI, Ryousuke**
  **Mishima-gun**
  **Osaka 618-8589 (JP)**
- **KONDOU, Syunsuke**
  **Mishima-gun**
  **Osaka 618-8589 (JP)**

(74) Representative: **Merkle, Gebhard**
**TER MEER STEINMEISTER & PARTNER GbR,**
**Patentanwälte**
**Mauerkircherstrasse 45**
**81679 München (DE)**

# (54) INSULATING SHEET AND LAMINATED STRUCTURE

(57) The present invention provides an insulating sheet which is excellent in handleability when it is uncured, prevents excessive flowage in laminating press, and provides a cured product excellent in dielectric breakdown characteristics, thermal conductivity, heat resistance, and processability. The insulating sheet used for bonding a heat conductor having a thermal conductivity of 10 W/m·K or higher to an electrically conductive layer, comprising: (A) a polymer having a weight average molecular weight of 10,000 or more; (B) at least one of an epoxy monomer (B1) having an aromatic skeleton and a weight average molecular weight of 600 or less and an oxetane monomer (B2) having an aromatic skeleton and a weight average molecular weight of 600 or less; (C) a curing agent; and (D) 20 to 60% by volume of a first inorganic filler; and (E) 1 to 40% by volume of at least one of an organic filler (E1), and a second inorganic filler (E2) that is different from the first inorganic filler (D) and has a new Mohs' hardness of 3 or less and, when the filler (E) contains the organic filler (E1), 3 to 40% by volume of the organic filler (E1).

[FIG. 1]

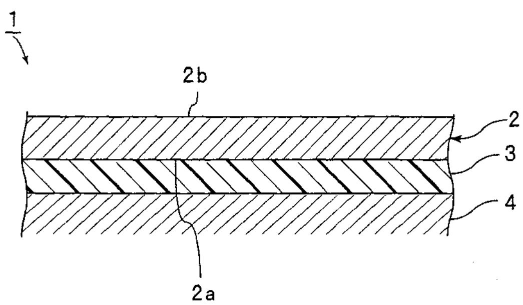


EP 2 316 897 A1

## Description

### TECHNICAL FIELD

The present invention relates to an insulating sheet used for bonding a heat conductor having a thermal conductivity of 10 W/m·K or higher to an electrically conductive layer and a laminated structure produced by the use of the insulating sheet.

### BACKGROUND ART

Electrical apparatuses have recently been downsized and allowed to have higher performance, and thus electronic components have been mounted with a higher package density. Such a situation makes it much important to dissipate heat generated from the electronic components. As a widely employed heat dissipation method, a heat conductor having high heat-dissipation capability and a thermal conductivity of 10 W/m·K or higher, such as aluminum, is bonded to a heat source. For bonding the heat conductor to the heat source, an insulating adhesive material is used. The insulating adhesive material is required to have a high thermal conductivity.
As one example of the insulating adhesive material, Patent Document 1 discloses an insulating adhesive sheet in which glass cloth is impregnated with an adhesive composition containing an epoxy resin, a curing agent for an epoxy resin, a curing accelerator, an elastomer, and an inorganic filler.
Insulating adhesive materials free from glass cloth are also known. For example, Patent Document 2 discloses in EXAMPLES an insulating adhesive containing a bisphenol A epoxy resin, a phenoxy resin, phenol novolac, 1-cyanoethyl-2-phenylimidazole, γ-glycidoxypropyltrimethoxysilane, and alumina. Patent Document 2 discloses, as examples of the curing agent for an epoxy resin, tertiary amines, acid anhydrides, imidazole compounds, polyphenol resins, and mask-isocyanates.

Patent Document 1: JP 2006-342238 A
Patent Document 2: JP H08-332696 A

### DISCLOSURE OF THE INVENTION

The insulating adhesive sheet of Patent Document 1 is formed by the use of glass cloth for higher handleability. In the case of using glass cloth, it is difficult to make an insulating adhesive sheet thin, and it is also difficult to perform various processing such as laser processing, punching, and drill piercing on the insulating adhesive sheet. Further, a cured product of a glass cloth-containing insulating adhesive sheet has a relatively low thermal conductivity, and thus it has insufficient heat dissipation capability in some cases. In addition, impregnation of the glass cloth with the adhesive composition requires special equipment.
The insulating adhesive of Patent Document 2 is formed without glass cloth, so that it does not have the aforementioned problems. However, this insulating adhesive itself does not have self supportability when it is uncured. Thus, the handleability of the insulating adhesive is poor.
An object of the present invention is to provide an insulating sheet which is used for bonding a heat conductor having a thermal conductivity of 10 W/m·K or higher to an electrically conductive layer, is excellent in handleability when it is uncured, prevents excessive flowage in laminating press, and provides a cured product excellent in dielectric breakdown characteristics, thermal conductivity, heat resistance, and processability. Another object of the present invention is to provide a laminated structure formed by the use of the insulating sheet.
According to a broad aspect of the present invention, an insulating sheet used for bonding a heat conductor having a thermal conductivity of 10 W/m·K or higher to an electrically conductive layer, comprises: (A) a polymer having a weight average molecular weight of 10,000 or more; (B) at least one of an epoxy monomer (B1) having an aromatic skeleton and a weight average molecular weight of 600 or less and an oxetane monomer (B2) having an aromatic skeleton and a weight average molecular weight of 600 or less; (C) a curing agent; and (D) a first inorganic filler; and (E) at least one of an organic filler (E1), and a second inorganic filler (E2) that is different from the first inorganic filler (D) and has a new Mohs' hardness of 3 or less, wherein an amount of the first inorganic filler (D) is 20 to 60% by volume, and an amount of the filler (E) is 1 to 40% by volume and, when the filler (E) contains the organic filler (E1), an amount of the organic filler (E1) is 3 to 40% by volume.
The filler (E) is preferably the organic filler (E1) and an amount of the organic filler (E1) is preferably 3 to 40% by volume. Use of the organic filler (E1) allows the cured product of the insulating sheet to have much higher processability. In a specific aspect of the insulating sheet according to the present invention, the first inorganic filler (D) has a thermal conductivity of 10 W/m·K and a new Mohs' hardness of 3.1 or higher.
In another specific aspect of the insulating sheet according to the present invention, the filler (E) is the second

inorganic filler (E2) and an amount of the second inorganic filler (E2) is 1 to 40 % by volume.

In still another aspect of the insulating sheet according to the present invention, the first inorganic filler (D) and the second inorganic filler (E2) satisfy a following formula (X):

$$[\{(\text{New Mohs' hardness of first inorganic filler (D)}) \times (\text{Amount (\% by volume) of first inorganic filler (D) in 100\% by volume of insulating sheet})\} + \{(\text{New Mohs' hardness of second inorganic filler (E2)}) \times (\text{Amount (\% by volume) of second inorganic filler (E2) in 100\% by volume of insulating sheet})\}] < 6 \ldots (X)$$

In another specific aspect of the insulating sheet according to the present invention, the second inorganic filler (E2) is at least one substance selected from the group consisting of diatom earth, boron nitride, aluminum hydroxide, magnesium hydroxide, calcium carbonate, talc, kaolin, clay, and mica.

In a different specific aspect of the insulating sheet according to the present invention, the organic filler (E1) has a core-shell structure.

In a still different specific aspect of the insulating sheet according to the present invention, the organic filler (E1) is a composite filler comprising an organic substance and a compound having a skeleton in which an oxygen atom is directly bonded to a silicon atom.

The first inorganic filler (D) is preferably at least one substance selected from the group consisting of alumina, synthetic magnesite, crystalline silica, aluminum nitride, silicon nitride, silicon carbide, zinc oxide, and magnesium oxide. Use of such a preferable inorganic filler (D) allows the cured product of the insulating sheet to have much higher heat dissipation capability.

In another specific aspect of the insulating sheet according to the present invention, the polymer (A) has an aromatic skeleton and a weight average molecular weight of 30,000 or more.

The polymer (A) is preferably a phenoxy resin. Use of a phenoxy resin allows the cured product of the insulating sheet to have much higher heat resistance. Further, the phenoxy resin preferably has a glass transition temperature Tg of 95°C or higher. The phenoxy resin having a Tg of 95°C or higher is more likely to avoid heat degradation of the resin.

In another specific aspect of the insulating sheet according to the present invention, the curing agent (C) is a phenol resin, or an acid anhydride having an aromatic skeleton or an alicyclic skeleton, a hydrogenated product of the acid anhydride, or a modified product of the acid anhydride.

The curing agent (C) is preferably a first acid anhydride having a polyalicyclic skeleton, a hydrogenated product of the first acid anhydride, or a modified product of the first acid anhydride, or a second acid anhydride having an alicyclic skeleton formed by addition reaction between a terpene compound and maleic anhydride, a hydrogenated product of the second acid anhydride, or a modified product of the second acid anhydride. Further, the curing agent (C) is preferably an acid anhydride represented by any one of the following formulas (1) to (3). Use of these preferable curing agents (C) allows the insulating sheet to have much higher flexibility, moisture resistance, or adhesion.

[Chem. 1]

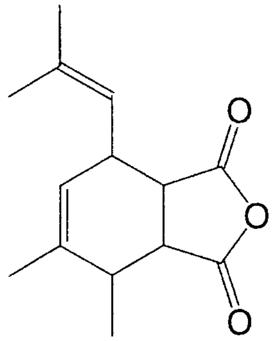

... Formula (1)

[Chem. 2]

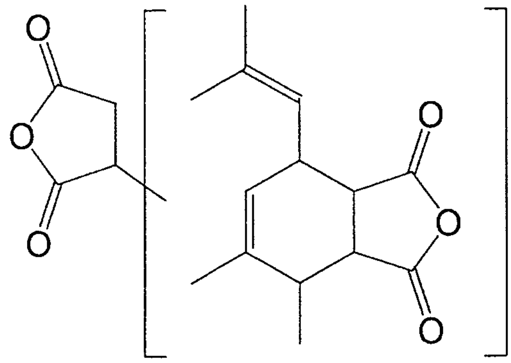

... Formula (2)

[Chem. 3]

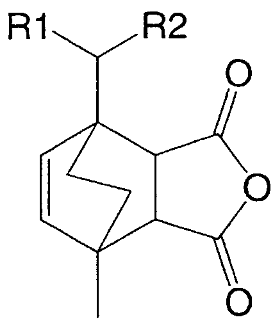

... Formula (3)

In the formula (3), R1 and R2 each represent hydrogen, a C1-C5 alkyl group, or a hydroxy group.

The curing agent (C) is preferably a phenol resin having a melamine skeleton or a triazine skeleton, or a phenol resin having an allyl group. Use of this preferable curing agent (C) allows the cured product of the insulating sheet to have much higher flexibility and flame retardancy.

A laminated structure according to the present invention includes: a heat conductor having a thermal conductivity of 10 W/m·K or higher; an insulating layer laminated on at least one side of the heat conductor; and an electrically conductive layer laminated on the insulating layer on the other side of the insulating sheet. The insulating layer is formed by curing the insulating sheet according to the present invention.

In the laminated structure of the present invention, the heat conductor is preferably made of metal.

**Effects of the invention**

The insulating sheet according to the present invention contains the components of (A) to (E) and the amount of the inorganic filler (D) and the filler (E) is in the specific range. This allows the cured product of the insulating sheet to have higher thermal conductivity and processability. For example, it is possible to prevent abrasion of the die used for punching or drill-piercing the cured product of the insulating sheet.

The components of (A) to (E) contained in the insulating sheet according to the present invention allows the insulating sheet to have higher handleability when it is uncured and prevents excessive flowage of the uncured insulating sheet in laminating press. In addition, these components also allow the cured product of the insulating sheet to have higher dielectric breakdown characteristics, thermal conductivity, and heat resistance.

The laminated structure according to the present invention includes the electrically conductive layer laminated on at least one side of the heat conductor having a thermal conductivity of 10 W/m·K or higher via the insulating layer. The insulating layer is formed by curing the insulating sheet according to the present invention, so that heat from the side of the electrically conductive layer is likely to be transmitted to the heat conductor through the insulating layer. Thus, the heat is efficiently dissipated through the heat conductor.

**BRIEF DESCRIPTION OF THE DRAWING**

Fig. 1 is a partially-cutout cross-sectional front view schematically showing a laminated structure according to one embodiment of the present invention.

**EXPLANATION OF SYMBOLS**

1. Laminated structure
2. Heat conductor
2a. One side
2b. The other side
3. Insulating layer
4. Electrically conductive layer

**BEST MODE FOR CARRYING OUT THE INVENTION**

The present inventors have found out that the following composition allows the cured product of the insulating sheet to have higher thermal conductivity and processability. Namely, the composition contains (A) a polymer having a weight average molecular weight of 10,000 or more; (B) at least one of an epoxy monomer (B1) having an aromatic skeleton and a weight average molecular weight of 600 or less and an oxetane monomer (B2) having an aromatic skeleton and a weight average molecular weight of 600 or less; (C) a curing agent; and above specific amount of (D) a first inorganic filler; and (E) at least one of an organic filler (E1), and a second inorganic filler (E2) that is different from the first inorganic filler (D) and has a new Mohs' hardness of 3 or less.

Moreover, the present inventors have also found out that the above composition allows the insulating sheet to have higher handleability when it is uncured, prevents excessive flowage of the uncured insulating sheet in laminating press, and allows the cured product of the insulating sheet to have higher dielectric breakdown characteristics and heat resistance.

In the following, the present invention is specifically described.

The insulating sheet according to the present invention comprises (A) a polymer having a weight average molecular weight of 10, 000 or more; (B) at least one of an epoxy monomer (B1) having an aromatic skeleton and a weight average molecular weight of 600 or less and an oxetane monomer (B2) having an aromatic skeleton and a weight average molecular weight of 600 or less; and (E) at least one of an organic filler (E1), and a second inorganic filler (E2) that is different from the first inorganic filler (D) and has a new Mohs' hardness of 3 or less.

(Polymer (A))

The polymer (A) contained in the insulating sheet according to the present invention is not particularly limited as long as it has a weight average molecular weight of 10,000 or more. The polymer (A) preferably has an aromatic

skeleton. In this case, the cured product of the insulating sheet is allowed to have much higher heat resistance. In the case of having an aromatic skeleton, the polymer (A) may contain an aromatic skeleton at any moiety of the whole polymer, and may contain an aromatic skeleton in the main chain skeleton or in the side chain. The polymer (A) preferably contains an aromatic skeleton in the main chain skeleton. In this case, the cured product of the insulating sheet is allowed to have much higher heat resistance. The polymer (A) may be used alone, or two or more polymers (A) may be used in combination.

The aforementioned aromatic skeleton is not particularly limited. Specific examples of the aromatic skeleton include a naphthalene skeleton, a fluorene skeleton, a biphenyl skeleton, an anthracene skeleton, a pyrene skeleton, a xanthene skeleton, an adamantine skeleton, and a bisphenol A skeleton. In particular, a biphenyl skeleton or a fluorene skeleton is preferable. In this case, the cured product of the insulating sheet is allowed to have much higher heat resistance.

The polymer (A) may be a thermoplastic resin or a thermosetting resin.

The thermoplastic resin and the thermosetting resin are not particularly limited. Examples of the thermoplastic resin and the thermosetting resin include thermoplastic resins such as polyphenylene sulfide, polyarylate, polysulfone, polyethersulfone, polyetheretherketone, and polyetherketone. In addition, the examples of the thermoplastic resin and the thermosetting resin further include heat-resistant resins, which are so-called super engineering plastics, such as thermoplastic polyimide, thermosetting polyimide, benzoxazine, and a reaction product of polybenzoxazole and benzoxazine. Each of the thermoplastic resins may be used alone, or two or more of these may be used in combination. Also, each of the thermosetting resins may be used alone, or two or more of these may be used in combination. Either one of a thermoplastic resin or a thermosetting resin may be used, or both of a thermoplastic resin and a thermosetting resin may be used in combination.

The polymer (A) is preferably a styrenic polymer, a (meth)acrylic polymer, or a phenoxy resin, more preferably a styrenic polymer or a phenoxy resin, and still more preferably a phenoxy resin. In this case, the cured product of the insulating sheet is allowed to have resistance against oxidation aging and much higher heat resistance.

Specific examples of the styrenic polymer include polymers containing only styrenic monomers or copolymers containing styrenic monomers and acrylic monomers. Particularly preferable are styrenic polymers having a styrene-glycidyl methacrylate structure.

Examples of the styrenic monomer include styrene, o-methylstyrene, m-methylstyrene, p-methylstyrene, p-methoxystyrene, p-phenylstyrene, p-chlorostyrene, p-ethylstyrene, p-n-butylstyrene, p-tert-butylstyrene, p-n-hexylstyrene, p-n-octylstyrene, p-n-nonylstyrene, p-n-decylstyrene, p-n-dodecylstyrene, 2,4-dimethylstyrene, and 3,4-dichlorostyrene.

Examples of the acrylic monomer include acrylic acid, methacrylic acid, methyl acrylate, ethyl acrylate, butyl acrylate, 2-ethylhexyl acrylate, cyclohexyl acrylate, phenyl acrylate, methyl methacrylate, ethyl methacrylate, butyl methacrylate, hexyl methacrylate, 2-ethylhexyl methacrylate, glycidyl methacrylate, ethyl β-hydroxy acrylate, propyl-γ-amino acrylate, stearyl methacrylate, dimethylaminoethyl methacrylate, and diethylaminoethyl methacrylate.

Specifically, the phenoxy resin is a resin formed by the reaction between epihalohydrin and a dihydric phenol compound or a resin formed by the reaction between a dihydric epoxy compound and a dihydric phenol compound.

The phenoxy resin preferably has at least one skeleton selected from the group consisting of a bisphenol A skeleton, a bisphenol F skeleton, a bisphenol A/F mixed skeleton, a naphthalene skeleton, a fluorene skeleton, a biphenyl skeleton, an anthracene skeleton, a pyrene skeleton, a xanthene skeleton, an adamantane skeleton, and a dicyclopentadiene skeleton. In particular, the phenoxy resin more preferably has at least one skeleton selected from the group consisting of a bisphenol A skeleton, a bisphenol F skeleton, a bisphenol A/F mixed skeleton, a naphthalene skeleton, a fluorene skeleton, and a biphenyl skeleton. The phenoxy resin further preferably has at least one of a fluorene skeleton and a biphenyl skeleton. Use of the phenoxy resin having such preferable skeletons allows the cured product of the insulating sheet to have much higher heat resistance.

The phenoxy resin preferably has a polycyclic aromatic skeleton in the main chain. The phenoxy resin more preferably has at least one of the skeletons represented by the formulas (4) to (9) in the main chain.

[Chem. 4]

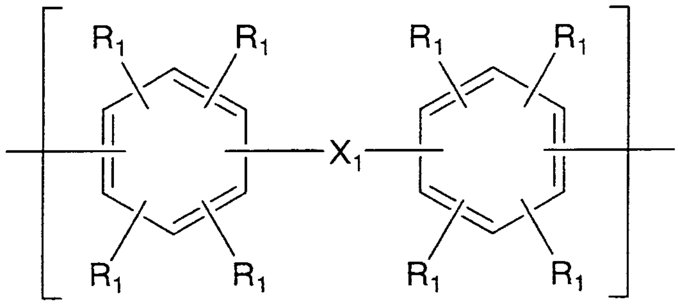

... Formula(4)

In the formula (4), $R_1$s each may be the same as or different from each other, and are a hydrogen atom, a C1-C10 hydrocarbon group, or a halogen atom; and $X_1$ is a single bond, a C1-C7 dihydric hydrocarbon group, -O-, -S-, $-SO_2-$, or -CO-.

[Chem. 5]

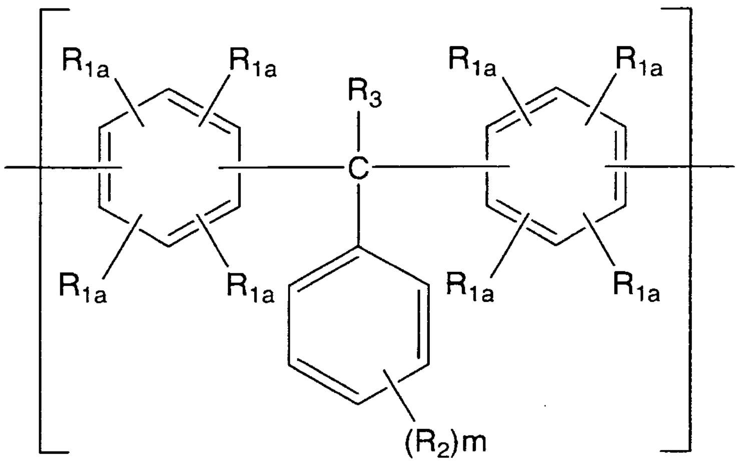

... Formula(5)

In the formula (5), $R_{1a}$s each may be the same as or different from each other, and are a hydrogen atom, a C1-C10 hydrocarbon group, or a halogen atom; $R_2$ is a hydrogen atom, a C1-C10 hydrocarbon group, or a halogen atom; $R_3$ is a hydrogen atom or a C1-C10 hydrocarbon group; and m is an integer of 0 to 5.

[Chem. 6]

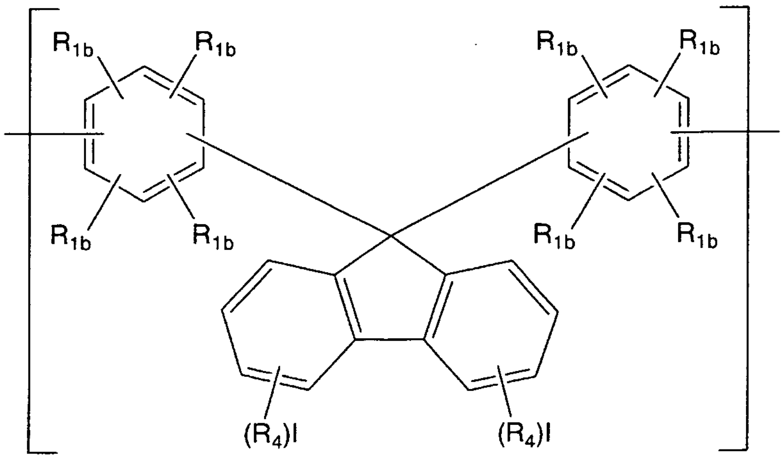

... Formula (6)

In the formula (6), $R_{1b}$s each may be the same as or different from each other, and are a hydrogen atom, a C1-C10 hydrocarbon group, or a halogen atom; $R_4$s each may be the same as or different from each other, and are a hydrogen atom, a C1-C10 hydrocarbon group, or a halogen atom; and 1 is an integer of 0 to 4.

[Chem. 7]

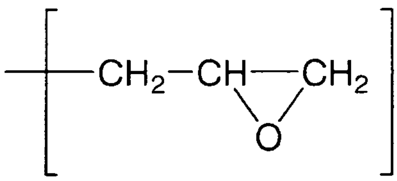

... Formula (7)

[Chem. 8]

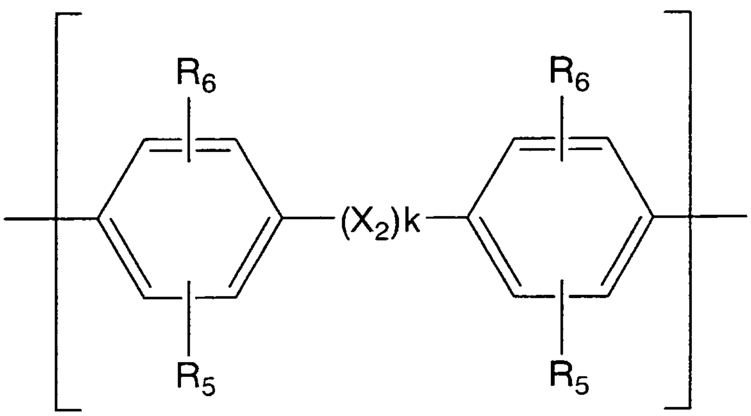

... Formula (8)

In the formula (8), $R_5$s and $R_6$s each is a hydrogen atom, a C1-C5 alkyl group, or a halogen atom; $X_2$ is $-SO_2-$, $-CH_2-$, $-C(CH_3)_2-$, or -O-; and k is 0 or 1.

[Chem. 9]

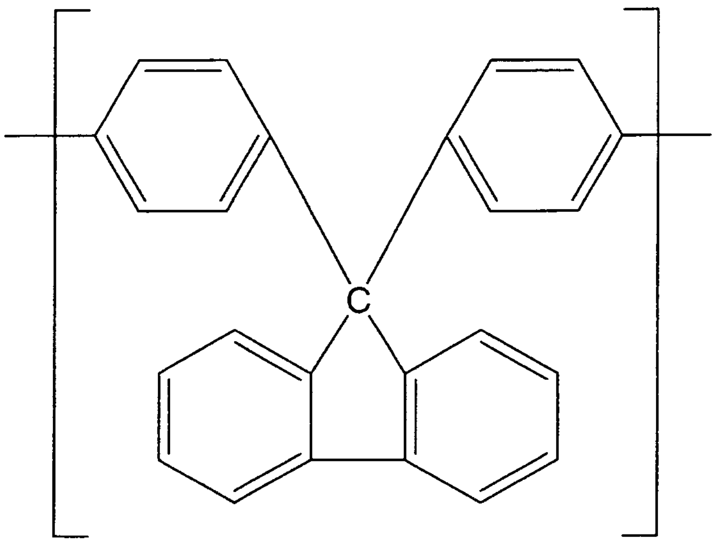

... Formula (9)

For example, a phenoxy resin represented by the following formula (10) or (11) may be suitably used as the aforementioned polymer (A).

[Chem. 10]

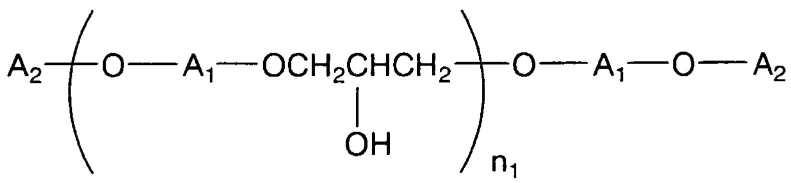

... Formula (10)

In the formula (10), $A_1$ has the structures represented by any of the formulas (4) to (6), and the structure of the formula (4) occupies 0 to 60 mol%, the structure of the formula (5) occupies 5 to 95 mol%, and the structure of the formula (6) occupies 5 to 95 mol%; $A_2$ is a hydrogen atom or a group represented by the formula (7); and $n_1$ is 25 to 500 on average.

[Chem. 11]

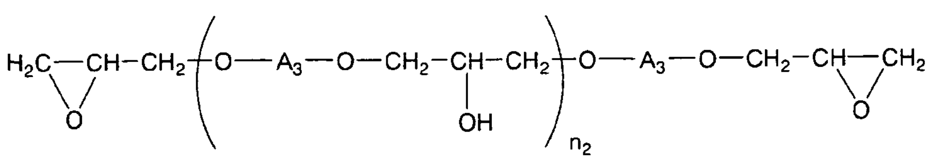

... Formula (11)

In the formula (11), $A_3$ has the structure represented by the formula (8) or (9) ; and $n_2$ is not less than 21.

The polymer (A) has a glass transition temperature Tg of preferably 60°C to 200°C, and more preferably 90°C

to 180°C. A too low Tg of the polymer (A) may cause heat aging of the resin. A too high Tg of the polymer (A) may cause poor compatibility of the polymer (A) with other resins. In these cases, the handleability of the uncured insulating sheet may be poor, and the cured product of the insulating sheet may have poor heat resistance.

In the case where the polymer (A) is a phenoxy resin, the phenoxy resin has a glass transition temperature Tg of preferably 95°C or higher, and more preferably 110°C to 200°C, and particularly preferably 110°C to 180°C. A too low Tg of the phenoxy resin may cause heat aging of the resin. A too high Tg of the phenoxy resin may cause poor compatibility of the phenoxy resin with other resins. In these cases, the handleability of the uncured insulating sheet may be poor, and the cured product of the insulating sheet may have poor heat resistance.

The polymer (A) preferably has a hydrogen-bonding functional group containing a hydrogen atom. A polymer having a hydrogen-bonding functional group containing a hydrogen atom is highly compatible with a first inorganic filler (D) or a filler (E). Accordingly, the dispersibility of the first inorganic filler (D) or the filler (E) in the insulating sheet and the adhesion between the polymer (A) and the first inorganic filler (D) or the filler (E) are allowed to be improved. Therefore, the cured product of the insulating sheet is allowed to have much higher dielectric breakdown characteristics and thermal conductivity without having a gap in the interface between the resin layer and the first inorganic filler (D) or the filler (E).

Examples of the hydrogen-bonding functional group containing a hydrogen atom in the polymer (A) include a hydroxy group (pKa=16), a phosphate group (pKa=7), a carboxyl group (pKa=4), and a sulfonate group (pKa=2).

The hydrogen-bonding functional group containing a hydrogen atom in the polymer (A) is preferably at least one functional group selected from the group consisting of a hydroxy group, a phosphate group, a carboxyl group, and a sulfonate group, more preferably at least one functional group selected from the group consisting of a phosphate group, a carboxyl group, and a sulfonate group. Use of the polymer (A) having such a favorable functional group allows the cured product of the insulating sheet to have much higher dielectric breakdown characteristics and thermal conductivity.

From the standpoint of further improving the dielectric breakdown characteristics and thermal conductivity of the cured product of the insulating sheet, the polymer (A) preferably has a carboxyl group or a phosphate group as a hydrogen-bonding functional group containing a hydrogen atom.

The hydrogen-bonding functional group containing a hydrogen atom preferably has a pKa of 2 to 10, and more preferably 3 to 9. When the pKa is lower than 2, the acidity of the polymer (A) is too high which tends to promote the reaction of the epoxy and the oxetane in the polymer (A). This may result in the insufficient storage stability of the uncured insulating sheet. When the pKa is higher than 10, the dispersibility of the first inorganic filler (D) or the filler (E) in the insulating sheet may be not sufficiently improved. This may cause a difficulty in sufficiently improving the dielectric breakdown characteristics and thermal conductivity of the cured product of the insulating sheet.

Examples of the polymer (A) having a hydrogen-bonding functional group containing a hydrogen atom include a polymer having a hydrogen-bonding functional group containing a hydrogen atom such as a carboxylic acid group, a sulfonate group, a phosphate group, and a hydroxy group. Examples of a method for obtaining such a polymer include copolymerization of a monomer having a hydrogen-bonding functional group containing a hydrogen atom with another monomer, graft copolymerization of a stock polymer as a base with a hydrogen-bonding functional group containing a hydrogen atom, and conversion of a derivative of a hydrogen-bonding functional group containing a hydrogen atom in a polymer to a hydrogen-bonding functional group containing a hydrogen atom.

Specific examples of the polymer having a hydrogen-bonding functional group containing a hydrogen atom include a styrenic polymer containing a carboxylic acid group, a phenoxy resin containing a carboxylic acid group, polyester containing a carboxylic acid group, polyether containing a carboxylic acid group, a (meth)acrylic polymer containing a carboxylic acid group, an aliphatic polymer containing a carboxylic acid group, a polysiloxane polymer containing a carboxylic acid group, a styrenic polymer containing a phosphate group, a phenoxy resin containing a phosphate group, polyester containing a phosphate group, polyether containing a phosphate group, an acrylic polymer containing a phosphate group, an aliphatic polymer containing a phosphate group, a polysiloxane polymer containing a phosphate group, a styrenic polymer containing a sulfonate group, a phenoxy resin containing a sulfonate group, polyester containing a sulfonate group, polyether containing a sulfonate group, a (meth) acrylic polymer containing a sulfonate group, an aliphatic polymer containing a sulfonate group, a polysiloxane polymer containing a sulfonate group, a styrenic polymer containing a hydroxy group, a phenoxy resin containing a hydroxy group, a phenoxy resin containing a hydroxy group, polyester containing a hydroxy group, polyether containing a hydroxy group, a (meth)acrylic polymer containing a hydroxy group, an aliphatic polymer containing a hydroxy group, and a polysiloxane polymer containing a hydroxy group. The polymer (A) having a hydrogen-bonding functional group containing a hydrogen atom may be used alone, or two or more polymers (A) may be used in combination.

The polymer (A) has a weight average molecular weight of 10,000 or more. The weight average molecular weight of the polymer (A) is preferably 30, 000 or more, more preferably in the range of 30, 000 to 1,000,000, and further preferably in the range of 40,000 to 250,000. A too low weight average molecular weight of the polymer (A) may cause heat aging of the insulating sheet. A too high weight average molecular weight of the polymer (A) may cause poor

compatibility of the polymer (A) with other resins. In these cases, the handleability of the insulating sheet may be poor and the cured product of the insulating sheet may have poor heat resistance.

The insulating sheet contains 20 to 60% by weight of the polymer (A) in 100% by weight of all the resin components including the polymer (A) , the monomer (B) , and the curing agent (C). Preferably, the amount of the polymer (A) is in the aforementioned range, and the total amount of the polymer (A) and the monomer (B) is less than 100% by weight. The lower limit of the amount of the polymer (A) is more preferably 30% by weight and the upper limit thereof is more preferably 50% by weight, in 100% by weight of all the resin components. A too small amount of the polymer (A) may cause poor handleability of the uncured insulating sheet. A too large amount of the polymer (A) may cause difficulty in dispersing the first inorganic filler (D) and the filler (E). Here, "all the resin components" include the polymer (A), the epoxy monomer (B1), the oxetane monomer (B2), the curing agent (C), and the other resin components added if necessary. The organic filler (E1) is not included in "all the resin components".

(Monomer (B))

The insulating sheet according to the present invention contains at least one monomer (B) of an epoxy monomer (B1) having an aromatic skeleton and a weight average molecular weight of 600 or less and an oxetane monomer (B2) having an aromatic skeleton and a weight average molecular weight of 600 or less. The insulating sheet may contain, as the monomer (B) , only the epoxy monomer (B1), only the oxetane monomer (B2), or both of the epoxy monomer (B1) and the oxetane monomer (B2).

The epoxy monomer (B1) is not particularly limited as long as it has an aromatic skeleton and a weight average molecular weight of 600 or less. Specific examples of the epoxy monomer (B1) include an epoxy monomer having a bisphenol skeleton, an epoxy monomer having a dicyclopentadiene skeleton, an epoxy monomer having a naphthalene skeleton, an epoxy monomer having an adamantane skeleton, an epoxy monomer having a fluorene skeleton, an epoxy monomer having a biphenyl skeleton, an epoxy monomer having a bi(glycidyloxyphenyl)methane skeleton, an epoxy monomer having a xanthene skeleton, an epoxy monomer having an anthracene skeleton, and an epoxy monomer having a pyrene skeleton. Each of these epoxy monomers (B1) may be used alone, or two or more of these may be used in combination.

Examples of the epoxy monomer having a bisphenol skeleton include an epoxy monomer having a bisphenol A skeleton, a bisphenol F skeleton, or a bisphenol S skeleton.

Examples of the epoxy monomer having a dicyclopentadiene skeleton include a phenol novolac epoxy monomer having a dicyclopentadiene dioxide skeleton or a dicyclopentadiene skeleton.

Examples of the epoxy monomer having a naphthalene monomer include 1-glycidyl naphthalene, 2-glycidyl naphthalene, 1,2-diglycidyl naphthalene, 1,5-diglycidyl naphthalene, 1,6-diglycidyl naphthalene, 1,7-diglycidyl naphthalene, 2,7-diglycidyl naphthalene, triglycidyl naphthalene, and 1,2,5,6-tetraglycidyl naphthalene.

Examples of the epoxy monomer having an adamantane skeleton include 1,3-bis(4-glycidyloxyphenyl)adamantane and 2,2-bis(4-glycidyloxyphenyl)adamantane.

Examples of the epoxy monomer having a fluorene skeleton include 9,9-bis(4-glycidyloxyphenyl)fluorene, 9,9-bis(4-glycidyloxy-3-methylphenyl)fluorene, 9,9-bis(4-glycidyloxy-3-chlorophenyl)fluorene, 9,9-bis(4-glycidyloxy-3-bromophenyl)fluorene, 9,9-bis(4-glycidyloxy-3-fluorophenyl)fluorene, 9,9-bis(4-glycidyloxy-3-methoxyphenyl)fluorene, 9,9-bis(4-glycidyloxy-3,5-dimethylphenyl)fluorene, 9,9-bis(4-glycidyloxy-3,5-dichlorophenyl)fluorene, and 9,9-bis(4-glycidyloxy-3,5-dibromophenyl)fluorene.

Examples of the epoxy monomer having a biphenyl skeleton include 4,4'-diglycidylbiphenyl and 4,4'-diglycidyl-3,3',5,5'-tetramethylbiphenyl.

Examples of the epoxy monomer having a bi(glycidyloxyphenyl)methane skeleton include 1,1'-bi(2,7-glycidyloxynaphthyl)methane, 1,8'-bi(2,7-glycidyloxynaphthyl)methane, 1,1'-bi(3,7-glycidyloxynaphthyl)methane, 1,8'-bi(3,7-glycidyloxynaphthyl)methane, 1,1'-bi(3,5-glycidyloxynaphthyl)methane, 1,8'-bi(3,5-glycidyloxynaphthyl)methane, 1,2'-bi(2,7-glycidyloxynaphthyl)methane, 1,2'-bi(3,7-glycidyloxynaphthyl)methane, and 1,2'-bi(3,5-glycidyloxynaphthyl) methane.

Examples of the epoxy monomer having a xanthene skeleton include 1,3,4,5,6,8-hexamethyl-2,7-bis-oxiranylmethoxy-9-phenyl-9H-xanthene.

The oxetane monomer (B2) is not particularly limited as long as it has an aromatic skeleton and a weight average molecular weight of 600 or less. Specific examples of the oxetane monomer (B2) include 4,4'-bis[(3-ethyl-3-oxetanyl)methoxymethyl]biphenyl, 1,4-benzenedicarboxylic acid bis[(3-ethyl-3-oxetanyl)methyl]ester, 1,4-bis[(3-ethyl-3-oxetanyl)methoxymethyl]benzene, and oxetane-modified phenol novolac. Each of these oxetane monomers (B2) may be used alone, or two or more of these may be used in combination.

The monomer (B) preferably has a hydroxy group equivalent of 6000 or less. When the hydroxy group equivalent of the monomer (B) is 6000 or less, the uncured insulating sheet is allowed to have further improved handleability. The hydroxy group equivalent of the monomer (B) is more preferably 6,500 or more, further preferably 7, 000 or more, and

most preferably 15,000 or more.

The hydroxy group equivalent of the monomer (B) is obtained by determining the amount (W mol%) of the hydroxy group with respect to the entire resin (B) with use of a high-speed liquid chromatography-mass spectrometry (LC-MS) or a $^1$H-nuclear magnetic resonance spectroscopy ($^1$H-NMR) and assigning the obtained value to the following equation.

The hydroxy group equivalent = (Weight average molecular weight/W) x 100

The monomer (B) preferably has a theoretical chemical structure purity of 90% or higher, more preferably 95% or higher, and further preferably 97% or higher. The higher the theoretical chemical structure purity of the monomer (B) is, the higher the handleability of the uncured insulating sheet becomes.

The "theoretical chemical structure purity" refers to the percentage of a monomer having a three-membered (epoxy) or four-membered (oxetane) cyclic ether structure and having no hydroxy group.

The monomer (B) is preferably at least one of a distilled epoxy monomer and a distilled oxetane monomer, and more preferably the distilled epoxy monomer. In this case, the uncured insulating sheet is allowed to have much higher handleability.

The weight average molecular weight of the epoxy monomer (B1) and the oxetane monomer (B2), that is , the weight average molecular weight of the monomer (B), is less than 600. The preferable lower limit of the weight average molecular weight of the monomer (B) is 200, and the upper limit thereof is preferably 550. The monomer (B) having a too low weight average molecular weight may cause too high volatility of the monomer (B), resulting in poor handleability of the insulating sheet. The monomer (B) having a too high weight average molecular weight may make the insulating sheet hard and brittle, resulting in poor adhesion of the cured product of the insulating sheet.

The insulating sheet preferably contains 10 to 60% by weight, more preferably 10 to 40% by weight of the monomer (B) in 100% by weight of all the resin components including the polymer (A), the monomer (B), and the curing agent (C). The amount of the monomer (B) is preferably in the above range while the total amount of the polymer (A) and the monomer (B) is less than 100% by weight. A too small amount of the monomer (B) may cause the cured product of the insulating sheet to have poor adhesion and heat resistance. A too large amount of the monomer (B) may cause the insulating sheet to have poor flexibility.

(Curing agent (C))

The curing agent (C) contained in the insulating sheet according to the present invention is not particularly limited. The curing agent (C) is preferably a phenol resin, an acid anhydride having an aromatic skeleton or an alicyclic skeleton, a hydrogenated product of the acid anhydride, or a modified product of the acid anhydride. This preferable curing agent (C) provides the cured product of the insulating sheet having an excellent balance among heat resistance, moisture resistance, and electric properties. The curing agent (C) may be used alone, or two or more of the curing agents (C) may be used in combination.

The phenol resin is not particularly limited. Specific examples of the phenol resin include phenol novolac, o-cresol novolac, p-cresol novolac, t-butyl phenol novolac, dicyclopentadiene cresol, polyparavinyl phenol, bisphenol A novolac, xylylene-modified novolac, decalin-modified novolac, poly(di-o-hydroxyphenyl)methane, poly(di-m-hydroxyphenyl)methane, and poly(di-p-hydroxyphenyl)methane. In particular, a phenol resin having a melamine skeleton, a phenol resin having a triazine skeleton, or a phenol resin having an allyl group is preferable as these phenol resins allow the insulating sheet to have much higher flexibility and flame retardancy.

Commercially available products of the phenol resin include MEH-8005, MEH-8010, and NEH-8015 (produced by Meiwa Plastic Industries, Ltd.); YLH903 (produced by Japan Epoxy Resins Co., Ltd.); LA-7052, LA-7054, LA-7751, LA-1356, and LA-3018-50P (produced by Dainippon Ink and Chemicals, Corp.); and PS6313 and PS6492 (produced by Gunei Chemical Industry Co., Ltd.).

The acid anhydride having an aromatic skeleton, the hydrogenated product of the acid anhydride, or the modified product of the acid anhydride is not particularly limited. Examples of the acid anhydride having an aromatic skeleton, the hydrogenated product of the acid anhydride, or the modified product of the acid anhydride include copolymers of styrene and maleic anhydride, benzophenone tetracarboxylic anhydrides, pyromellitic anhydride, trimellitic anhydride, 4,4'-oxydiphthalic anhydride, phenylethynylphthalic anhydride, glycerol bis(anhydrotrimellitate)monoacetate, ethyleneglycol bis(anhydrotrimellitate), methyltetrahydrophthalic anhydride, methylhexahydrophthalic anhydride, and trialkyltetrahydrophthalic anhydrides. In particular, a methyl nadic anhydride or a trialkyltetrahydrophthalic anhydride is preferable. The methyl nadic anhydride and the trialkyltetrahydrophthalic anhydride allow the cured product of the insulating sheet to have higher water resistance.

Commercially available products of the acid anhydride having an aromatic skeleton, the hydrogenated product of the acid anhydride, or the modified product of the acid anhydride include SMA resin EF30, SMA resin EF40, SMA resin EF60, and SMA resin EF80 (produced by Sartomer Japan Inc.); ODPA-M and PEPA (produced by MANAC Inc.); RIKACID MTA-10, RIKACID MTA-15, RIKACID TMTA, RIKACID TMEG-100, RIKACID TMEG-200, RIKACID TMEG-300, RIKACID TMEG-500, RIKACID TMEG-S, RIKACID TH, RIKACID HT-1A, RIKACID HH, RIKACID MH-700, RIKACID MT-500, RIKACID DSDA, and RIKACID TDA-100 (produced by New Japan Chemical Co., Ltd.); and EPICLON B4400, EPICLON B650, and EPICLON B570 (produced by Dainippon Ink and Chemicals, Corp.).

Further, the acid anhydride having an alicyclic skeleton, the hydrogenated product of the acid anhydride, or the modified product of the acid anhydride is preferably a first acid anhydride having a polyalicyclic skeleton, a hydrogenated product of the first acid anhydride, or a modified product of the first acid anhydride, or a second acid anhydride formed by addition reaction of a terpene compound and maleic anhydride, a hydrogenated product of the second acid anhydride, or a modified product of the second acid anhydride. In this case, the insulating sheet is allowed to have much higher flexibility, moisture resistance, or adhesion. In addition, the acid anhydride having an alicyclic skeleton, the hydrogenated product of the acid anhydride, or the modified product of the acid anhydride may be a methyl nadic anhydride, an acid anhydride having a dicyclopentadiene skeleton, or a modified product of either of the acid anhydrides.

Commercially available products of the first acid anhydride having an alicyclic skeleton, the hydrogenated product of the first acid anhydride, or the modified product of the first acid anhydride include RIKACID HNA and RIKACID HNA-100 (produced by New Japan Chemical Co., Ltd.); and EPIKURE YH306, EPIKURE YH307, EPIKURE YH308H, and EPIKURE YH309 (produced by Japan Epoxy Resins Co., Ltd.).

The curing agent (C) is preferably an acid anhydride represented by any one of the following formulas (1) to (3). This preferable curing agent (C) allows the insulating sheet to have much higher flexibility, moisture resistance, or adhesion.

[Chem. 12]

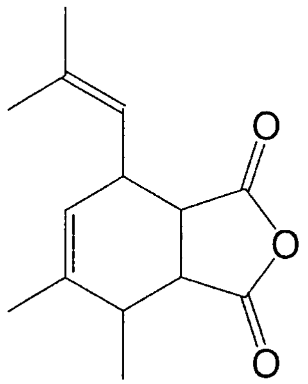

... Formula (1)

[Chem. 13]

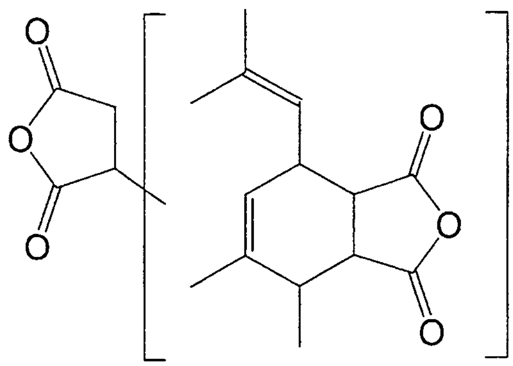

... Formula (2)

[Chem. 14]

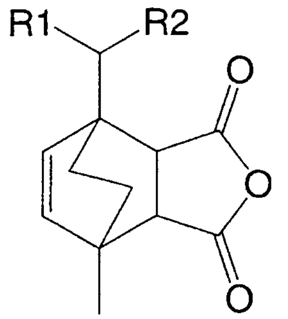

... Formula (3)

In the formula (3), R1 and R2 each are hydrogen, a C1-C5 alkyl group, or a hydroxy group.

In addition to the curing agent, a curing accelerator may be contained in the insulating sheet for adjusting a curing rate and physical properties of the cured product.

The curing accelerator is not particularly limited. Specific examples of the curing accelerator include tertiary amines, imidazoles, imidazolines, triazines, organophosphorus compounds, and diazabicycloalkenes such as quaternary phosphonium salts and organic acid salts. Examples of the curing accelerator further include organic metal compounds, quaternary ammonium salts, and halogenated metals. Examples of the organic metal compound include zinc octylate, tin octylate, and aluminum-acetyl-acetone complexes.

Examples of the curing accelerator include imidazole curing accelerators with a high melting point, dispersible latent curing accelerators with a high melting point, micro-capsulated latent curing accelerators, amine salt latent curing accelerators, and high-temperature dissociative and thermal cation polymerizable latent curing accelerators. Each of these curing accelerators may be used alone, or two or more of these may be used in combination.

Examples of the dispersible latent accelerator with a high melting point include amine-addition accelerators in which dicyanamide or amine is added to an epoxy monomer. Examples of the micro-capsulated latent accelerator include micro-capsulated latent accelerators formed by covering the surface of an accelerator such as an imidazole accelerator, a phosphorus accelerator, or a phosphine accelerator with a polymer. Examples of the high-temperature dissociative and thermal cation polymerizable latent curing accelerator include Lewis acid salts and Bronsted acid salts.

The curing accelerator is preferably an imidazole curing accelerator with a high melting point. The imidazole curing accelerator with a high melting point enables easy control of the reaction system and much easier adjustment of the curing rate of the insulating sheet and the physical properties of the cured product of the insulating sheet. A curing accelerator with a high melting point of 100°C or higher may be excellently easy to handle. Thus, the curing accelerator preferably has a melting point of 100°C or higher.

The insulating sheet contains preferably 10 to 40% by weight of the curing agent (C) in 100% by weight of all the resin components including the polymer (A), the monomer (B), and the curing agent (C). The lower limit of the amount of the curing agent is more preferably 12% by weight and the upper limit thereof is more preferably 25% by weight, in 100% by weight of all the resin components. A too small amount of the curing agent (C) may cause difficulty in sufficiently curing the insulating sheet. A too large amount of the curing agent (C) may generate the exces curing agent which is not involved in the curing or may cause insufficient cross-linking of the cured product. This may cause the cured product of the insulating sheet to have insufficient heat resistance and adhesion.

(First inorganic filler (D))

The first inorganic filler (D) contained in the insulating sheet according to the present invention allows the cured product of the insulating sheet to have higher heat dissipation capability.

The first inorganic filler (D) preferably has a thermal conductivity of 10 W/m·K or more. When the first inorganic filler (D) has a thermal conductivity of 10 W/m·K or more, the cured product of the insulating sheet is allowed to have much higher thermal conductivity. The lower limit of the thermal conductivity of the first inorganic filler (D) is more preferably 15 W/m·K and still more preferably 20 W/m·K. The upper limit of the thermal conductivity of the first inorganic filler (D) is not particularly limited. The inorganic filler having a thermal conductivity of about 300 W/m·K is widely known and the inorganic filler having a thermal conductivity of about 200 W/m·K is readily available.

The first inorganic filler (D) preferably has a new Mohs' hardness of 3.1 or higher. When an inorganic filler

having a new Mohs' hardness of 3.1 or higher is used, the cured product of the insulating sheet tends to have poor processability. However, the amount of the first inorganic filler (D) is limited within a predetermined range, and the filler (E) is used in combination with the first inorganic filler (D) in order to compensate the disadvantage of the first inorganic filler (D). Therefore, the cured product of the insulating sheet is allowed to have sufficient processability without reducing the thermal conductivity. The lower limit of the new Mohs' hardness of the first inorganic filler (D) is preferably 4 and the upper limit thereof is preferably 14. A too high Mohs' hardness of the first inorganic filler may make it difficult to secure both fine thermal conductivity and fine processability in the cured product of the insulating sheet.

The first inorganic filler (D) is not particularly limited. Only one first inorganic filler (D) may be used, or two or more first inorganic fillers (D) may be used in combination. The first inorganic filler (D) is preferably at least one substance selected from the group consisting of alumina, synthetic magnesite, crystalline silica, boron nitride, aluminum nitride, silicon nitride, silicon carbide, zinc oxide, and magnesium oxide. More preferably, the first inorganic filler (D) is preferably at least one substance selected from the group consisting of alumina, boron nitride, aluminum nitride, silicon nitride, silicon carbide, zinc oxide, and magnesium oxide. Use of such a preferable filler (D) allows the cured product of the insulating sheet to have much higher heat dissipation capability.

Since the first inorganic filler (D) has a new Mohs' hardness of 3.1 or higher, the first inorganic filler (D) is preferably at least one substance selected from the group consisting of alumina, synthetic magnesite, crystalline silica, aluminum nitride, silicon nitride, silicon carbide, zinc oxide, and magnesium oxide. Use of such a preferable inorganic filler (D) allows the cured product of the insulating sheet to have much higher heat dissipation capability.

The first inorganic filler (D) is more preferably one substance selected from the group consisting of spherical alumina, crushed alumina, and spherical aluminum nitride, and more preferably spherical alumina or spherical aluminum nitride. In this case, the cured product of the insulating sheet is allowed to have mush higher heat dissipation capability.

The first inorganic filler (D) may be a spherical filler or a crushed filler.

Examples of the crushed filler include crushed alumina. The crushed filler is obtained by crushing a massive inorganic substance with use of, for example, a single-shaft crusher, a double-shaft crusher, a hammer crusher, or a ball mill. Use of the crushed filler is more likely to provide the insulating sheet with a structure in which the first inorganic fillers (D) are efficiently cross-linked or approached to one another. This further improves the thermal conductivity of the cured product of the insulating sheet. Additionally, the crushed filler is inexpensive compared to a common filler. Therefore, use of the crushed filler reduces the production cost of the insulating sheet.

The crushed filler preferably has the average particle size of 12 μm or less. The average particle size of more than 12 μm may fail to disperse the crushed filler in the insulating sheet at a high density, leading to the lowered dielectric breakdown characteristics of the cured product of the insulating sheet. The upper limit of the average particle size of the crushed filler is more preferably 10 μm and the lower limit thereof is preferably 1 μm. A too small average particle size of the filler may make it difficult to fill the crushed filler into the insulating sheet at a high density.

The aspect ratio of the crushed filler is not particularly limited. The crushed filler preferably has an aspect ratio of 1.5 to 20. The filler having an aspect ratio of less than 1.5 is comparatively expensive so as to increase the production cost of the insulating sheet. It may be difficult to fill the crushed filler having an aspect ratio of more than 20 into the insulating sheet.

The aspect ratio of the crushed filler is obtained by measuring the crushed surface of the filler with use of a digital image processing particle size distribution measuring apparatus (product name: FPA, manufactured by NIHON RUFUTO CO., LTD.).

When the first inorganic filler (D) is a spherical filler, the average particle size thereof is preferably 0.1 to 40 μm. An average particle size of smaller than 0.1 μm may cause difficulty in filling the spherical filler into the insulating sheet at a high density. An average particle size exceeding 40 μm may cause the cured product of the insulating sheet to have poor dielectric breakdown characteristics.

The term "average particle size" herein represents an average particle size determined from the result of particle size distribution measurement in terms of volume average measured with a laser diffractive particle size distribution measuring apparatus.

The amount of the first inorganic filler (D) is 20 to 60% by volume in 100% by volume of the insulating sheet. The amount of the first inorganic filler (D) in the aforementioned range allows the cured product of the insulating sheet to have sufficiently high thermal conductivity and processability. The amount of the first inorganic filler (D) is in the aforementioned range while the total amount of the first inorganic filler (D) and the filler (E) is less than 100% by volume. The lower limit of the first inorganic filler (D) is preferably 30% by volume and the upper limit thereof is preferably 55% by volume, in 100% by volume of the insulating sheet. A too small amount of the first inorganic filler (D) may fail to sufficiently improve the heat dissipation capability of the cured product of the insulating sheet. A too large amount of the first inorganic filler (D) may lower the processability of the cured product of the insulating sheet. For example, the die is more likely to be abraded in processing of the cured product of the insulating sheet.

(Filler (E))

The insulating sheet according to the present invention contains at least one of an organic filler (E1), and a second inorganic filler (E2) that is different from the first inorganic filler (D) and has a new Mohs' hardness of 3 or less. Either one of an organic filler (E1) and a second inorganic filler (E2) may be used, or both of an organic filler (E1) and a second inorganic filler (E2) may be used in combination.

In order to improve the heat dissipation capability of the cured product of the insulating sheet, the amount of the first inorganic filler (D) may be increased. However, an inorganic filler such as alumina has a comparatively high new Mohs' hardness. Therefore, when the amount of the first inorganic filler (D) is increased, the die is more likely to be abraded during punching or drill piercing of the cured product of the insulating sheet. The amount of the first inorganic filler (D) may be reduced to avoid the abrasion of the die. However, when the amount of the first inorganic filler (D) is reduced, the amount of the resin components in the insulating sheet is relatively increased, leading to flowage of the insulating sheet in laminating press. Flowage of the insulating sheet may make the cured product of the insulating sheet too thin. As a result, the dielectric breakdown characteristics may be lowered.

In addition, when the amount of the first inorganic filler (D) is 20 to 60% by volume, the uncured insulating sheet problematically tends to flow in laminating press. However, the insulating sheet according to the present invention contains a predetermined amount of the filler (E) in addition to the first inorganic filler (D), and therefore, the processability of the cured product of the insulating sheet is not lowered. This avoids the abrasion of the die during the punching or the drill piercing of the cured product of the insulating sheet. Additionally, excessive flowage of the insulating sheet in laminating press is also avoided. Moreover, since the insulating sheet is less likely to flow, the cured product of the insulating sheet is allowed to have higher dielectric breakdown characteristics.

The filler (E) is preferably an organic filler (E1). The organic filler (E1) is comparatively flexible. Accordingly, use of the organic filler (E1) avoids excessive flowage of the uncured insulating sheet in laminating press without lowering the processability of the cured product of the insulating sheet.

The organic filler (E1) is preferably insoluble particles including a repeated structure formed by monomers. The monomers are preferably acrylic monomers or styrenic monomers.

Each of the acrylic monomers may be used alone, or two or more of them may be used in combination. Further, each of the styrenic monomers may be used alone, or two or more of them may be used in combination.

Examples of the acrylic monomers include acrylic acid, methacrylic acid, methyl acrylate, ethyl acrylate, butyl acrylate, 2-ethylhexyl acrylate, cyclohexyl acrylate, phenylacrylate, methylmethacrylate, ethyl methacrylate, butyl methacrylate, hexyl methacrylate, 2-ethylhexyl methacrylate, glycidyl methacrylate, β-ethyl hydroxy acrylate, γ-propylaminoacrylate, stearyl methacrylate, dimethylaminoethyl methacrylate, and diethylaminoethyl methacrylate. Each of the acrylic monomers may be used alone, or two or more of them may be used in combination.

Examples of the styrenic monomers include styrene, o-methylstyrene, m-methylstyrene, p-methylstyrene, p-methoxystyrene, p-phenylstyrene, p-chlorostyrene, p-ethylstyrene, p-n-butylstyrene, p-tert-butylstyrene, p-n-hexylstyrene, p-n-octylstyrene, p-n-nonylstyrene, p-n-decylstyrene, p-n-dodecylstyrene, 2,4-dimethylstyrene, and 3,4-dichlorostyrene. Each of the styrenic monomers may be used alone, or two or more of them may be used in combination.

The organic filler (E1) preferably has a core-shell structure. Use of the organic filler having a core-shell structure allows the cured product of the insulating sheet to have much higher heat resistance. The organic filler having a core-shell structure comprises a core layer and a shell layer covering the core layer. The core layer and the shell layer covering the core layer are preferably made of a acrylic compound.

The organic filler (E1) is preferably a composite filler containing an organic substance and a compound having a skeleton in which an oxygen atom is directly bonded to a silicon atom. In such a case, the cured product of the insulating sheet is allowed to have much higher heat resistance.

The core layer preferably contains the compound having a skeleton in which an oxygen atom is directly bonded to a silicon atom. The shell layer preferably contains the organic substance. The organic filler (E1) is preferably a composite filler comprising a core layer containing the compound having a skeleton in which an oxygen atom and a shell layer containing the organic substance.

The compound having a skeleton in which an oxygen atom is directly bonded to a silicon atom is preferably a siloxane polymer. The organic substance is preferably an acrylic compound.

The organic filler (E1) preferably has the average particle size of 0.4 to 40 μm. The upper limit of the average particle size of the organic filler (E1) is preferably 20 μm. A too small average particle size of the organic filler (E1) may make it difficult to fill the organic filler (E1) into the insulating sheet at a high density. A too large average particle size of the organic filler (E1) may lower the heat resistance of the cured product of the insulating sheet.

The term "average particle size" herein represents an average particle size determined from the result of particle size distribution measurement in terms of volume average measured with a laser diffractive particle size distribution measuring apparatus.

The filler (E) is preferably the second inorganic filler (E2) because it is possible to avoid excessive flowage of

the uncured insulating sheet in laminating press without lowering the processability of the cured product of the insulating sheet, and to further improve the heat dissipation capability and the heat resistance of the cured product of the insulating sheet.

The filler (E) is the second inorganic filler (E2), and the second inorganic filler (E2) is preferably one substance selected from the group consisting of diatom earth, boron nitride, aluminum hydroxide, magnesium hydroxide, calcium carbonate, talc, kaolin, clay, and mica, and more preferably talc. In such a case, the cured product of the insulating sheet is allowed to have much higher processability.

The second inorganic filler (E) may be a spherical filler or a crushed filler.

When the second inorganic filler (E2) is a spherical filler, the spherical filler preferably has the average particle size of 0.1 to 40 μm. The average particle size of less than 0.1 μm may make it difficult to fill the second inorganic filler (E2) into the insulating sheet at a high density. The average particle size of more than 40 μm may lower the dielectric breakdown characteristics of the cured product of the insulating sheet.

The term "average particle size" herein represents an average particle size determined from the result of particle size distribution measurement in terms of volume average measured with a laser diffractive particle size distribution measuring apparatus.

The amount of the filler (E) is 1 to 40% by volume in 100% by volume of the insulating sheet. When the filler (E) contains the organic filler (E1), the amount of the organic filler (E1) is 3 to 40% by volume in 100% by volume of the insulating sheet. The amount of the filler (E) is in the aforementioned range while the total amount of the inorganic filler (D) and the filler (E) is less than 100% by weight. The lower limit of the filler (E) is preferably 3% by volume, more preferably 5% by volume, and further preferably 10% by volume, in 100% by volume of the insulating sheet. The upper limit of the filler (E) is preferably 30% by volume and more preferably 20% by volume in 100% by volume of the insulating sheet. A too small amount of the filler (E) may fail to sufficiently avoid the flowage of the insulating sheet in laminating press. A too large amount of the filler (E) results in the too large total amount of the first inorganic filler (D) and the filler (E). This may lower the dielectric breakdown characteristics of the cured product of the insulating sheet. Also, this may make the uncured insulating sheet becomes hard and brittle so that the handleability of the uncured insulating sheet and the adhesion of the cured product of the insulating sheet are lowered.

When the insulating sheet only contains the organic filler (E1) as the filler (E), the lower limit of the amount of the organic filler (E1) is 3% by volume, preferably 5% by volume, and further preferably 10% by volume, in 100% by volume of the insulating sheet. The upper limit thereof is preferably 30% by volume and more preferably 20% by volume.

When the insulating sheet only contains the second inorganic filler (E2) as the filler (E), the lower limit of the amount of the second inorganic filler (E2) is 1% by volume, preferably 2% by volume, and more preferably 3% by volume, in 100% by volume of the insulating sheet. The upper limit thereof is preferably 30% by volume and more preferably 20% by volume.

The total amount of the first inorganic filler (D) and the filler (E) is preferably 30 to 90% by volume in 100% by volume of the insulating sheet. A too small total amount of the first inorganic filler (D) and the filler (E) may cause excessive flowage of the insulating sheet in laminating press. A too large total amount of the first inorganic filler (D) and the filler (E) may lower the dielectric breakdown characteristics, heat resistance, or copper peel strength of the cured product of the insulating sheet.

It is preferable that the filler (E) is the second inorganic filler (E2) and the first inorganic filler (D) and the second inorganic filler (E2) satisfy the following formula (X). In such a case, the cured product of the insulating sheet is allowed to have much higher processability.

[{(New Mohs' hardness of first inorganic filler

(D)) × (Amount (% by volume) of first inorganic filler (D) in 100% by volume of insulating sheet)} + {(New Mohs' hardness of second inorganic filler (E2)) × (Amount (% by volume) of second inorganic filler (E2) in 100% by volume of insulating sheet)}] < 6 ... (X)

The right-hand value of the formula (X) is 6, preferably 5.5, and more preferably 5. Namely, "< 6" in the formula (X) is preferably "< 5.5" and more preferably "< 5".

(Dispersant (F))

The insulating sheet according to the present invention preferably contains a dispersant (F). The dispersant (F) preferably has a hydrogen-bonding functional group containing a hydrogen atom. Containing the dispersant (F), the insulating sheet can provide a cured product having much higher thermal conductivity and dielectric breakdown characteristics.

Examples of the hydrogen-bonding functional group containing a hydrogen atom include a carboxyl group (pKa = 4), a phosphoric acid group (pKa = 7), and a phenol group (pKa = 10).

The hydrogen-bonding functional group containing a hydrogen atom in the dispersant (F) has a pKa of preferably 2 to 10, and more preferably 3 to 9. If the pKa is lower than 2, the dispersant (F) has a too high acidity, so that reactions of the epoxy resin and the oxetane resin in the resin component are likely to be accelerated. Accordingly, in the case that the uncured insulating sheet is stored, the uncured insulating sheet may have poor storage stability. If the pKa of the functional group is higher than 10, the dispersant (F) may insufficiently exert its effects, and the cured product of the insulating sheet may have insufficient thermal conductivity and dielectric breakdown characteristics.

The hydrogen-bonding functional group containing a hydrogen atom is preferably a carboxyl group or a phosphoric acid group. In this case, the cured product of the insulating sheet is allowed to have much higher thermal conductivity and dielectric breakdown characteristics.

Specific examples of the dispersant (F) include polyester carboxylic acids, polyether carboxylic acids, polyacrylic carboxylic acids, aliphatic carboxylic acids, polysiloxane carboxylic acids, polyester phosphoric acids, polyether phosphoric acids, polyacrylic phosphoric acids, aliphatic phosphoric acids, polysiloxane phosphoric acids, polyester phenols, polyether phenols, polyacrylic phenols, aliphatic phenols, and polysiloxane phenols. The dispersant (F) may be a single dispersant or a combination of two or more dispersants.

The insulating sheet contains preferably 0.01 to 20% by weight of the dispersant (F) in 100% by weight of the insulating sheet. The lower limit of the dispersant (F) is more preferably 0.1% by weight and the upper limit thereof is preferably 10% by weight, in 100% by weight of the insulating sheet. The dispersant (F) in an amount within this range may prevent agglomeration of the first inorganic filler (D) and the filler (E) and allow the cured product of the insulating sheet to have much higher thermal conductivity and dielectric breakdown characteristics.

(Other components)

The insulating sheet according to the present invention may contain a substrate material such as glass cloth, nonwoven glass fabric, or nonwoven aramid fabric for much better handleability. Here, the insulating sheet according to the present invention has self supportability without containing the substrate material even when it is uncured at room temperature (23°C), and the handleability thereof is excellent. Thus, the insulating sheet is preferably free from a substrate material, in particular, glass cloth. When being free from the substrate material, the insulating sheet may be made thin, and the cured product of the insulating sheet may have much higher thermal conductivity. Further, the insulating sheet may be easily subjected to processes such as laser processing and drilling if necessary. Here, the term "self supportability" means that the sheet is capable of retaining its shape and being handled as a sheet even without a supporting medium such as a PET film or a copper foil and even when it is uncured.

In addition, the insulating sheet according to the present invention may contain additives such as a thixotropic agent, a flame retardant, and a coloring agent.

(Insulating sheet)

The insulating sheet according to the present invention may be produced by any method. For example, the insulating sheet may be provided by mixing the aforementioned materials to prepare a mixture and then forming the mixture into a sheet through solvent casting or extrusion film formation. It is preferable to perform deaeration at the time of the sheet formation.

The thickness of the insulating sheet is not particularly limited. The thickness of the insulating sheet is preferably 10 to 300 μm. The lower limit of the thickness of the insulating sheet is more preferably 50 μm and further preferably 70 μm. The upper limit thereof is more preferably 200 μm and further preferably 120 μm. If the insulating sheet is too thin, the cured product of the insulating sheet may have poor insulating property. If the insulating sheet is too thick, the insulating sheet may have poor heat dissipation capability in the case of bonding a metal material to the electrically conductive layer.

A thick insulating sheet allows the cured product of the insulating sheet to have much better dielectric breakdown characteristics. Here, the insulating sheet according to the present invention allows the cured product of the insulating sheet to have high dielectric breakdown characteristics even when it is thin.

The insulating sheet has a glass transition temperature Tg of 25°C or lower when it is uncured. An insulating sheet having a glass transition temperature of higher than 25°C may be hard and brittle at room temperature and may lower the handleability of the uncured insulating sheet.

The cured product of the insulating sheet has a thermal conductivity of preferably 0.7 W/m·K or higher, more preferably 1.0 W/m·K or higher, and further preferably 1.5 W/m·K or higher. A cured product of the insulating sheet having a too low thermal conductivity may have insufficient heat dissipation capability.

The uncured insulating sheet preferably has a bending modulus of 10 to 1000 MPa, and more preferably 20 to 500 MPa, at 25°C. The uncured insulating sheet having a bending modulus of less than 10 MPa at 25°C may have significantly poor self supportability at room temperature, resulting in the poor handleability. When the bending modulus of the uncured insulating sheet is more than 1000 MPa at room temperature, the elasticity of the insulating sheet is not sufficiently lowered upon heat bonding. As a result, the cured product of the insulating sheet may not be sufficiently adhered to the adherent and the adhesion between the cured product of the insulating sheet and the adherent may be lowered.

The cured product of the insulating sheet preferably has a bending modulus of 1000 to 50, 000 MPa and more preferably 5,000 to 30,000 MPa at 25°C. If the cured product of the insulating sheet has a too-low bending modulus at 25°C, when such a insulating sheet is used to produce a laminated body such as a thin laminate substrate and a laminate plate provided with copper circuits on both faces, for example, the laminated body is more likely to be flexed. Therefore, the laminated body is more likely to be damaged by breaking or bending. If the cured product of the insulating sheet has a too-high bending modulus at 25°C, the cured product of the insulating sheet becomes too hard and brittle. This may easily cause a crack in the cured product of the insulating sheet.

The bending modulus may be measured in accordance with JIS K 7111 with use of a sample that measures 8 cm long, 1 cm wide, and 4 mm thick by using a universal testing machine RTC-1310A (product of Orientec Corp.) under conditions of the span of 6 cm and the rate of 1. 5 mm/min. In the case of measuring the bending modulus of the cured product of the insulating sheet, the cured product of the insulating sheet is obtained by curing the insulating sheet at 120°C for one hour and then 200°C for one hour.

The insulating sheet according to the present invention preferably has a tanδ at 25°C, measured with a rotating dynamic viscoelasticity measuring apparatus, of 0.1 to 1.0 when it is uncured, and the insulating sheet preferably has a maximum tanδ of 1.0 to 5.0 when the uncured insulating sheet is heated from 25°C to 250°C. The tanδ of the insulating sheet is more preferably 0.1 to 0.5. The maximum tanδ of the insulating sheet is more preferably 1.5 to 4.0.

If the uncured insulating sheet has a tanδ at 25°C of lower than 0.1, the uncured insulating sheet may have poor flexibility and is likely to be damaged. If the uncured insulating sheet has a tanδ at 25°C of higher than 1.0, the uncured insulating sheet may be too soft and the handleability of the uncured insulating sheet may be poor.

If the insulating sheet has a maximum tanδ of lower than 1.0 when the uncured insulating sheet is heated from 25°C to 250°C, the insulating sheet may insufficiently adhere to an adherent upon heat bonding. If the aforementioned maximum tanδ of the insulating sheet is higher than 5.0, the insulating sheet may have too high fluidity and the insulating sheet may be thin upon heat bonding. Thus, desired dielectric breakdown characteristics may not be obtained.

The tanδ at 25°C of the uncured insulating sheet may be measured with a 2-cm diameter disc-shaped uncured insulating sheet by means of a rotating dynamic viscoelasticity measuring apparatus VAR-100 (product of REOLOGICA Instruments AB) with a 2-cm diameter parallel plate at a temperature of 25°C, an initial stress of 10 Pa, a frequency of 1 Hz, and a strain of 1% in an oscillation strain controlling mode. Further, the maximum tanδ of the insulating sheet when the uncured insulating sheet is heated from 25°C to 250°C may be measured by heating the uncured insulating sheet from 25°C to 250°C at a heating rate of 30°C/min under the aforementioned conditions.

In the case where the bending modulus and the tanδ each are in the aforementioned specific range, the

handleability of the uncured insulating sheet is remarkably high upon the production and the use thereof. Further, the bonding strength of the insulating sheet is remarkably high in the case of bonding a high-heat conductor such as a copper foil or an aluminum plate to the electrically conductive layer. Furthermore, in the case where the high-heat conductor has projected and recessed portions on its bonded surface, the insulating sheet is allowed to highly follow the projected and recessed portions. Thus, voids are less likely to be formed at the bonding interface, so that the insulating sheet is allowed to have higher thermal conductivity.

The cured product of the insulating sheet preferably has a dielectric breakdown voltage of preferably 30 kV/mm or higher, more preferably 40 kV/mm or higher, further preferably 50 kV/mm or higher, furthermore preferably 80 kV/mm or higher, and most preferably 100 kV/mm or higher. The cured product of the insulating sheet having a too low dielectric breakdown voltage may exert an insufficient insulating property when used in large-current applications such as electric power elements.

The insulating sheet preferably has a reaction ratio of 10% or less when it is uncured. When the uncured insulating sheet has a reaction ratio of higher than 10%, the uncured insulating sheet may be hard and brittle, and the handleability of the uncured insulating sheet at room temperature may be poor or the cured product of the insulating sheet may have lowered adhesion. The reaction ratio of the insulating sheet is calculated from the calorie generated upon curing of the insulating sheet at 120°C for one hour and then at 200°C for one hour which is measured by means of a differential scanning calorimetry.

The cured product of the insulating sheet has a volume resistivity of preferably $10^{14}$ Ω·cm or higher, and more preferably $10^{16}$ Ω·cm or higher. If the volume resistivity is too low, insulation between the electrically conductive layer and the heat conductor may not be sufficiently retained.

The cured product of the insulating sheet has a coefficient of linear thermal expansion of preferably 30 ppm/°C or lower, and more preferably 20 ppm/°C or lower. A cured product of the insulating sheet having a too high coefficient of linear thermal expansion may have poor heat resistance.

(Laminated structure)

The insulating sheet according to the present invention is used for bonding the heat conductor having a thermal conductivity of 10 W/m·K or higher to the electrically conductive layer. Further, the insulating sheet according to the present invention is suitably used as the material of an insulating layer of the laminated structure in which the electrically conductive layer is laminated on at least one side of the heat conductor having a thermal conductivity of 10 W/m·K or higher via the insulating layer.

Fig. 1 is a laminated structure according to one embodiment of the present invention.

A laminated structure 1 illustrated in Fig. 1 includes a heat conductor 2; an insulating layer 3 laminated on one side 2a of the heat conductor 2; and an electrically conductive layer 4 laminated on the insulating layer 3 on the other side of the insulating sheet. The insulating layer 3 is formed by curing the insulating sheet according to the present invention. The heat conductor 2 has a thermal conductivity of 10 W/m·K or higher.

The laminated structure 1 has the insulating layer 3 and the electrically conductive layer 4 in the stated order at least on the one side 2a of the heat conductor 2. The laminated structure may have an insulating layer and an electrically conductive layer in the stated order also on the other side 2b of the heat conductor 2.

The insulating layer 3 of the laminated structure 1 has high thermal conductivity, and heat from the electrically conductive layer 4 side is easily transmitted through the insulating layer 3 to the heat conductor 2. In the laminated structure 1, the heat conductor 2 enables heat to be sufficiently dissipated.

For example, the laminated structure 1 may be provided by bonding a metal material to an electrically conductive layer, such as a laminate plate or a multilayer wiring board with copper circuits provided on both sides thereof, a copper foil, a copper plate, a semiconductor element, or a semiconductor package, via the insulating sheet, and then curing the insulating sheet.

The heat conductor having the thermal conductivity of 10 W/m·K or higher is not particularly limited. Examples of the heat conductor having a thermal conductivity of 10 W/m·K or higher include aluminum, copper, alumina, beryllia, silicon carbide, silicon nitride, aluminum nitride, and a graphite sheet. In particular, the heat conductor having a thermal conductivity of 10 W/m·K or higher is preferably copper or aluminum. Copper and aluminum are excellent in heat dissipation capability.

The insulating sheet of the present invention is suitably used for bonding a heat conductor having a thermal conductivity of 10 W/m·K or higher to an electrically conductive layer of a semiconductor device with a semiconductor element mounted on a substrate. The insulating sheet of the present invention is also suitably used for bonding a heat conductor having a thermal conductivity of 10 W/m·K or higher to an electrically conductive layer of an electronic component device with an electronic component other than semiconductor elements mounted on a substrate.

In the case where the semiconductor element is a power supply device element for large current applications, a cured product of the insulating sheet is required to have a much more excellent insulating property or heat resistance.

Thus, the insulating sheet of the present invention is suitably used in such applications.

The present invention is clearly disclosed hereinbelow with reference to, but not limited to, specific examples and comparative examples.

The following materials were prepared.

[Polymer (A)]

(1) Bisphenol A phenoxy resin (product of Japan Epoxy Resins Co., Ltd., product name: E1256, Mw = 51,000, Tg = 98°C)
(2) High heat resistant phenoxy resin (product of Tohto Kasei Co., Ltd., product name: FX-293, Mw = 43,700, Tg = 163°C)
(3) Epoxy-group containing styrene resin (product of NOF Corporation, product name: Marproof G-1010S, Mw = 100,000, Tg = 93°C)
(4) Carboxyl-group containing acrylic resin (product of Shin-Nakamura Chemical Co., Ltd., product name: PSY-130, Mw = 30,000, Tg = 109°C)
(5) Sulfonic-acid-group containing styrene resin (product of Nippon NSC Co., Ltd,, product name: VERSA-TL 72, Mw = 70,000, Tg = 98°C)
(6) Phospholic-acid-group containing acrylic resin (synthesized in Synthesis Example 1, Mw = 12,000, Tg = 97°C)

(Synthesis Example 1)

A flask having a thermometer, a stirrer, a dropping funnel, and a reflux condenser was charged with 0.7 mole of methyl methacrylate and 0.3 mole of glycidyl methacrylate, and then with methyl ethyl ketone as a solvent and azobisisobutyronitrile as a catalyst. The solution was stirred for 18 hours at 80°C under nitrogen atmosphere. After that, the solution was cooled and methylhydroquinone as a polymerization inhibitor was added to the mixture. An amount of 1 mole of water was added to the solution, and the solution was stirred at 40°C while 0.1 mole of phosphoric anhydride was gradually added to the solution. Thereafter, reaction was allowed to occur for three hours, and thereby a polymer solution containing phosphate groups was prepared.

[Polymer other than polymer (A)]

(1) Epoxy-group containing acrylic resin (product of NOF Corporation, product name: Marproof G-0130S, Mw = 9,000, Tg = 69°C)

[Epoxy monomer (B1)]

(1) Bisphenol A liquid epoxy resin (product of Japan Epoxy Resins Co., Ltd., product name: EPIKOTE 828US, Mw = 370, hydroxyl group equivalent: 3,000, theoretical chemical structure purity: 87%)
(2) Bisphenol F liquid epoxy resin (product of Japan Epoxy Resins Co. , Ltd. , product name: EPIKOTE 806L, Mw = 370, hydroxyl group equivalent: 2,500, theoretical chemical structure purity: 87%)
(3) Trifunctional glycidyl amine liquid epoxy resin (product of Japan Epoxy Resins Co. , Ltd., product name: EPIKOTE 630, Mw = 300, hydroxyl group equivalent: 3,700, theoretical chemical structure purity: 92%)
(4) Fluorene skeleton epoxy resin (product of Osaka Gas Chemicals Co., Ltd., product name: Oncoat EX1011, Mw = 486, hydroxyl group equivalent: 2,300, theoretical chemical structure purity: 81%)
(5) Naphthalene skeleton liquid epoxy resin (Distilled naphthalene skeleton liquid epoxy resin, product of Dainippon Ink and Chemicals, Corp., product name: EPICLON HP-4032D, Mw = 304, hydroxyl group equivalent: 7,000, theoretical chemical structure purity: 98%)
(6) Distilled bisphenol A liquid epoxy resin (product of Tohto Kasei Co. , Ltd. product name: YD-8125, Mw = 350, hydroxyl group equivalent: 17,000, theoretical chemical structure purity: 99%)
(7) Distilled bisphenol F liquid epoxy resin (product of Tohto Kasei Co., Ltd., product name: YDF-8170C, Mw = 320, hydroxyl group equivalent: 16,000, theoretical chemical structure purity: 99%)

[Oxetane monomer (B-2)]

(1) Benzene skeleton oxetane resin (product of Ube Industries, Ltd., product name: ETERNACOLL OXTP, Mw = 362.4, hydroxyl group equivalent: 6,500, theoretical chemistry structure purity: 97%)

[Monomer other than epoxy monomer (B1) and oxetane monomer (B2)]

(1) Hexahydro phthalate skeleton liquid epoxy resin (product of Nippon Kayaku Co., Ltd., product name: AK-601, Mw = 284, hydroxyl group equivalent: 2,800, theoretical chemistry structure purity: 90%)
(2) Bisphenol A solid epoxy resin (product of Japan Epoxy Resins Co., product name: 1003, Ltd., Mw = 1300, hydroxyl group equivalent: 380, hydroxyl group-containing mixture, low theoretical chemical structure purity due to the hydroxyl groups)

[Curing agent (C)]

(1) Alicyclic skeleton acid anhydride (product of New Japan Chemical Co., Ltd., product name: MH-700)
(2) Aromatic skeleton acid anhydride (product of Sartomer Japan Inc., product name: SMA resin EF60)
(3) Polyalicyclic skeleton acid anhydride (product of New Japan Chemical Co., Ltd., product name: HNA-100)
(4) Terpene skeleton acid anhydride (product of Japan Epoxy Resins Co., Ltd., product name: EPIKURE YH-306)
(5) Biphenyl skeleton phenol resin (product of Meiwa Plastic Industries, Ltd., product name: MEH-7851-S)
(6) Allyl skeleton phenol resin (product of Japan Epoxy Resins Co., Ltd., product name: YLH-903)
(7) Triazine skeleton phenol resin (product of Dainippon Ink and Chemicals, Corp., product name: PHENOLITE KA-7052-L2)
(8) Melamine skeleton phenol resin (Gunei Chemical Industry Co., Ltd., product name: PS-6492)
(9) Isocyanurate-modified solid dispersed imidazole (imidazole curing accelerator, product of Shikoku Chemicals Corp., product name: 2MZA-PW)

[First inorganic filler (D)]

(1) 5-μm crushed alumina (crushed filler, product of Nippon Light Metal Co., Ltd., product name: LT300C, average particle size: 5 μm, thermal conductivity: 36 W/m·K, New Mohs' hardness: 12)
(2) 2-μm crushed alumina (crushed filler, product of Nippon Light Metal Co., Ltd., product name: LS-242C, average particle size: 2 μm, thermal conductivity: 36 W/m·K, New Mohs' hardness: 12)
(3) 6-μm crushed aluminum nitride (crushed filler, product of TOYO ALUMINIUM K.K., product name: FLC, average particle size: 6 μm, thermal conductivity: 200 W/m·K, New Mohs' hardness: 11)
(4) Spherical alumina (product of Denki Kagaku Kogyo K. K., product name: DAM-10, average particle size: 10 μm, thermal conductivity: 36 W/m·K, New Mohs' hardness: 12)
(5) Synthetic magnesite (product of Konoshima Chemical Co. Ltd., product name: MSL, average particle size: 6 μm, thermal conductivity: 15 W/m·K, New Mohs' hardness: 3.5)
(6) Aluminum nitride (product of TOYO ALUMINIUM K.K., product name: TOYALNITE-FLX, average particle size: 14 μm, thermal conductivity: 200 W/m·K, New Mohs' hardness: 11)
(7) Crystalline silica (product of Tatsumori Ltd., product name: CRYSTALITE CMC-12, average particle size: 5 μm, thermal conductivity: 10 W/m·K, New Mohs' hardness: 7)
(8) Silicon carbide (product of Shinano Electric Refining Co., Ltd., product name: SHINANO-RUNDUM GP#700, average particle size: 17 μm, thermal conductivity: 125 W/m·K, New Mohs' hardness: 13)
(9) Zinc oxide (product of Sakai Chemical Industry Co., Ltd., product name: LPZINC-5, average particle size: 5 μm, thermal conductivity: 54 W/m·K, New Mohs' hardness: 5)
(10) Magnesium oxide (product of Sakai Chemical Industry Co., Ltd., product name: SMO Large Particle, average particle size: 1.1 μm, thermal conductivity: 35 W/m·K, New Mohs' hardness: 6)

[Organic filler (E1)]

(1) 0.1-μm particles (Core-shell type silicone acrylic particles, product of WACKER ASAHIKASEI SILICONE CO., LTD., product name: P22, average particle size: 0.1 μm, having a core-shell structure, containing an organic substance and a compound having a skeleton in which an oxygen atom is directly bonded to a silicon atom)
(2) 0.5-μm particles (Core-shell type organic particles, product of GANZ CHEMICAL CO., LTD., product name: AC-3355, average particle size: 0.5 μm, having a core-shell structure)
(3) 4-μm particles (acrylic particles, product of GANZ CHEMICAL CO., LTD., product name: GM-0401S, average particle size: 4 μm)

[Second inorganic filler (E2))

(1) Mica (product of YAMAGUCHI MICA CO., LTD., product name: SJ005, average particle size: 5 μm, New Mohs' hardness: 2.8)
(2) Talc (product of Nippon Talc Co. , Ltd. , product name: K-1, average particle size: 8 μm, New Mohs' hardness: 1)
(3) Boron nitride (product of SHOWA DENKO K.K., product name: UHP-1, average particle size: 8 μm, New Mohs' hardness: 2)
(4) Clay (product of SHIRAISHI CALCIUM KAISHA, Ltd., product name: ST-301, average particle size: 0.7 μm, New Mohs' hardness: 2)
(5) Kaolin (product of BASF JAPAN LTD., product name: ASP-400P, average particle size: 4.8 μm, New Mohs' hardness: 2.8)
(6) Aluminum hydroxide (product of Nippon Light Metal Co. , Ltd., product name: B-103, average particle size: 8 μm, New Mohs' hardness: 3)
(7) Magnesium hydroxide (product of Tateho Chemical Industries Co., Ltd., product name: PZ-1, average particle size: 1.2 μm, New Mohs' hardness: 2.5)
(8) Calcium carbonate (product of SHIRAISHI CALCIUM KAISHA, Ltd., product name: BF-300, average particle size: 8 μm, New Mohs' hardness: 3)
(9) Diatom earth (product of SHIRAISHI CALCIUM KAISHA, Ltd., product name: ST-C219, average particle size: 9 μm, New Mohs' hardness: 1.5)

[Dispersant (F)]

(1) Acrylic dispersant (product of BYK Japan KK, product name: Disperbyk-2070, having carboxyl groups with a pKa value of 4)
(2) Polyether dispersant (product of Kusumoto Chemicals, Ltd., product name: ED151, having phosphate groups with a pKa value of 7)

[Additive]

(1) Epoxy silane coupling agent (product of Shin-Etsu Chemical Co., Ltd., product name: KBE403)

[Solvent]

(1) Methylethyl ketone

(Example 1)

The materials were blended with one another and kneaded at a ratio (the unit for blending is part(s) by weight) shown in the following Table 1 with a homodisper to prepare an insulating material.
The prepared insulating material was applied to a 50-μm thick release PET sheet so that the thickness of the insulating material was 100 μm. The applied insulating material was dried for 30 minutes in a 90°C oven to prepare an insulating sheet on the PET sheet.

(Examples 2 to 22 and Comparative Examples 1 to 5)

Except that the kinds and amounts of the compounds were changed as shown in the following Tables 1 to 3, insulating materials were prepared in the same manner as in Example 1 and insulating sheets each were prepared on the PET film.

(Evaluations for Examples 1 to 22 and Comparative Examples 1 to 5)

(1) Handleability

Each laminated sheet including the PET sheet and the insulating sheet formed on the PET sheet was cut out into a plane shape having a size of 460 mm × 610 mm to provide a test sample. By the use of the provided test sample, the handleability upon peeling the uncured insulating sheet off the PET sheet at room temperature (23°C) was evaluated on the following criteria.

[Evaluation criteria of handleability]

o: The insulating sheet was not deformed and was easily peeled off.
Δ: The insulating sheet was peeled off, but the sheet was elongated or broken.
×: The insulating sheet was not peeled off.

(2) Thermal conductivity

Each insulating sheet was heated for one hour in a 120°C oven and then for one hour in a 200°C oven, so that the insulating sheet was cured. The thermal conductivity of the insulating sheet was measured with a thermal conductivity meter "Quick Thermal Conductivity Meter QTM-500" produced by Kyoto Electronics Manufacturing Co., Ltd.

(3) Dielectric breakdown voltage

Each insulating sheet was cut out into a plane shape having a size of 100 mm × 100 mm to prepare a test sample. The prepared test sample was cured for one hour in a 120°C oven and for one hour in a 200°C oven to prepare a cured product of the insulating sheet. The cured product of the insulating sheet was subjected to an application of an alternating voltage so that the voltage rose at a rate of 1 kV/sec. with a voltage resistance testing apparatus (MODEL7473, produced by EXTECH Electronics). The voltage at which the insulating sheet was broken was regarded as a dielectric breakdown voltage.

(4) Solder heat resistance

Each insulating sheet was sandwiched between a 1.5-mm thick aluminum plate and a 35-μm thick electrolytic copper foil. Then, the insulating sheet was press-cured at 120°C for one hour and at 200°C for another one hour while the pressure was retained at 4 MPa with a vacuum press to prepare a copper clad laminated plate. The prepared copper clad laminated plate was cut out into a size of 50 mm × 60 mm to prepare a test sample. The prepared test sample was allowed to float on a 288°C solder bath so that the copper foil side was put downward. The time period until the copper foil was expanded or peeled off was measured, and the solder heat resistance was evaluated on the following criteria.

[Evaluation criteria of solder heat resistance]

oo (double circle) : No expansion or peeling occurred even after ten minutes.
o: Expansion or peeling occurred after three minute and before ten minutes.
Δ: Expansion or peeling occurred after one minute and before three minutes.
×: Expansion or peeling occurred before one minute.

(5-1) Processability

Each insulating sheet was sandwiched between a 1.5-mm thick aluminum plate and a 35-μm thick electrolytic copper foil. Then, the insulating sheet was press-cured at 120°C for one hour and at 200°C for another one hour while

the pressure was retained at 4 MPa with a vacuum press to prepare a copper clad laminated plate. The prepared copper clad laminated plate was router-processed with a 2.0-mm diameter drill (produced by Union Tool Co., RA series) at a rotational speed of 30,000 and a table feed speed of 0.5 m/min. The processing distance at which a burr generated was measured, and the processability was evaluated on the following criteria.

[Evaluation criteria of processability]

o: Processable for 5 m or more without a burr.
Δ: Processable for 1 m or more and less than 5 m without a burr.
×: Processing for less than 1 m caused a burr.

(6) Protrusion amount in laminating press

A laminated sheet comprising a PET sheet and an insulating sheet formed on the PET sheet was cut out into a plane shape having a size of 13 cm × 5 cm, and the insulating sheet was peeled from the PET sheet. In addition, an aluminum plate (product of Engineering Test Service, JIS H4000 A5052P, Surface roughness in maximum height Rz: 1.1) in a plane shape having a size of 13 cm × 5 cm and a copper foil (product of FUKUDA METAL FOIL& POWDER Co., LTD., Electrolytic copper foil, CT-T8) in a plane shape having a size of 13 cm × 5 cm were prepared.

The insulating sheet was sandwiched between the rough face of the aluminum plate and the rough face of the copper foil to prepare a laminated body. The laminated body was heat-pressed at a pressure of 4 Mpa at 120°C for ten minutes. The weight of the protruded insulating sheet from the side of the pressed laminated body was measured and the protrusion amount of the insulating sheet was obtained by the following equation. The protrusion amount was evaluated on the following criteria.

Protrusion amount = (Weight of the protruded insulating sheet from the side of the insulating sheet after the press) / (Weight of the insulating sheet before the press) × 100

[Evaluation criteria of protrusion amount in laminating press]

o: The protrusion amount of the insulating sheet was less than 7%.
Δ: The protrusion amount of the insulating sheet was more than 7% and less than 10%.
×: The protrusion amount of the insulating sheet was more than 10%.

Tables 1 to 3 show the results.

[Table 1]

| | | | Examples | | | | | | | | |
|---|---|---|---|---|---|---|---|---|---|---|---|
| | | | 1 | 2 | 3 | 4 | 5 | 6 | 7 | 8 | 9 |
| Components (parts by weight) | Polymer (A) | Bisphenol A phenoxy resin | 7 | 7 | 7 | 4 | 9 | 4 | 7 | 7 | |
| | | Highly heat-resistant phenoxy resin | | | | | | | | | 7 |
| | | Epoxy group-containing styrene resin | | | | | | | | | |
| | Polymer other than polymer (A) | Epoxy group-containing acrylic resin | | | | | | | | | |
| | Epoxy monomer (B1) | Bisphenol A liquid epoxy resin | 4 | 4 | 4 | 2 | 5 | 5 | 4 | 4 | 4 |
| | | Bisphenol F liquid epoxy resin | | | | | | | | | |
| | | Trifunctional glycidyl diamine liquid epoxy resin | | | | | | | | | |
| | | Fluorene skeleton epoxy resin | | | | | | | | | |
| | | Naphthalene skeleton liquid epoxy resin | | | | | | | | | |
| | Oxetane monomer (B2) | Benzene-skeleton containing oxetane resin | | | | | | | | | |
| | Monomer other than monomers (B) | Hexahydrophthalate skeleton liquid epoxy resin | 2 | 2 | 2 | 1 | 2 | 2 | 2 | 2 | 2 |
| | | Bisphenol A solid epoxy resin | | | | | | | | | |
| | Curing agent (C) | Alicyclic skeleton acid anhydride | 3 | 3 | 3 | 2 | 4 | 4 | 3 | 3 | 3 |
| | | Aromatic skeleton acid anhydride | | | | | | | | | |
| | | Polyalicyclic skeleton acid anhydride | | | | | | | | | |
| | | Terpene skeleton acid anhydride | | | | | | | | | |
| | | Biphenyl skeleton phenol resin | | | | | | | | | |
| | | Allyl skeleton phenol resin | | | | | | | | | |
| | | Triazine skeleton phenol resin | | | | | | | | | |
| | | Melamine skeleton phenol resin | | | | | | | | | |
| | | Isocyanurate-modified solid dispersed imidazole | 1 | 1 | 1 | 1 | 1 | 1 | 1 | 1 | 1 |
| | First inorganic filler (D) | 5-μm crushed alumina | 51 | 51 | 51 | 60 | 40 | 36 | | | 51 |
| | | 2-μm crushed alumina | | | | | | | 51 | | |
| | | 6-μm crushed aluminum nitride | | | | | | | | 40 | |
| | Organic filler (E1) | 0.1-μm particles | 3 | | | 2 | 9 | 18 | 3 | 3 | 3 |
| | | 0.5-μm particles | | 3 | | | | | | | |
| | | 4-μm particles | | | 3 | | | | | | |
| | Additive | Epoxy silane coupling agent | 1 | 1 | 1 | 1 | 1 | 1 | 1 | 1 | 1 |
| | Solvent | Methylethyl ketone | 28 | 28 | 28 | 27 | 29 | 29 | 28 | 28 | 28 |
| Amount of polymer (A) (% by weight) *1 | | | 39 | 39 | 39 | 36 | 41 | 24 | 39 | 39 | 39 |
| Amount of monomer (B) (% by weight) *1 | | | 22 | 22 | 22 | 18 | 23 | 29 | 22 | 22 | 22 |
| Amount of curing agent (C) (% by weight) *1 | | | 22 | 22 | 22 | 27 | 23 | 29 | 22 | 22 | 22 |
| Amount of first inorganic filler (D) (% by volume) *2 | | | 43 | 43 | 43 | 59 | 32 | 24 | 43 | 43 | 43 |
| Amount of filler (E) (% by volume) *2 | | | 8.2 | 8.2 | 8.2 | 6.4 | 21 | 39 | 8.2 | 8.2 | 8.2 |
| Evaluation | Handleability | | ○ | ○ | ○ | ○ | ○ | ○ | ○ | ○ | ○ |
| | Thermal conductivity (W/m•K) | | 1.5 | 1.5 | 1.5 | 1.9 | 1.0 | 0.7 | 1.4 | 1.6 | 1.4 |
| | Dielectric breakdown voltage (kV/mm) | | 81 | 82 | 80 | 80 | 89 | 88 | 78 | 82 | 84 |
| | Solder heat resistance (288℃) | | ◎ | ◎ | ◎ | ◎ | ◎ | ○ | ◎ | ◎ | ◎ |
| | Processability | | ○ | ○ | ○ | △ | ○ | ○ | ○ | ○ | ○ |
| | Protrusion amount in laminating press (%) | | 5.9 | 5.9 | 6.1 | 3.9 | 4.8 | 4.2 | 6.3 | 6.1 | 5.0 |
| | | | ○ | ○ | ○ | ○ | ○ | ○ | ○ | ○ | ○ |

*1 The amount in 100% by weight of all the resin components, except for the organic filler (E1), in the insulating sheet
*2 The amount in 100% by volume of the insulating sheet including the organic filler (E1)

[Table 2]

| | | | Examples | | | | | | | | |
|---|---|---|---|---|---|---|---|---|---|---|---|
| | | | 10 | 11 | 12 | 13 | 14 | 15 | 16 | 17 | 18 |
| Components (parts by weight) | Polymer (A) | Bisphenol A phenoxy resin | | 7 | 7 | 7 | 7 | 7 | 7 | 7 | 7 |
| | | Highly heat-resistant phenoxy resin | | | | | | | | | |
| | | Epoxy group-containing styrene resin | 7 | | | | | | | | |
| | Polymer other than polymer (A) | Epoxy group-containing acrylic resin | | | | | | | | | |
| | Epoxy monomer (B1) | Bisphenol A liquid epoxy resin | 4 | | | | | | 4 | 4 | 4 |
| | | Bisphenol F liquid epoxy resin | | 4 | | | | | | | |
| | | Trifunctional glycidyl diamine liquid epoxy resin | | | 4 | | | | | | |
| | | Fluorene skeleton epoxy resin | | | | 4 | | | | | |
| | | Naphthalene skeleton liquid epoxy resin | | | | | 4 | | | | |
| | Oxetane monomer (B2) | Benzene-skeleton containing oxetane resin | | | | | | 4 | | | |
| | Monomer other than monomers (B) | Hexahydrophthalate skeleton liquid epoxy resin | 2 | 2 | 2 | 2 | 2 | 2 | 2 | 2 | 2 |
| | | Bisphenol A solid epoxy resin | | | | | | | | | |
| | Curing agent (C) | Alicyclic skeleton acid anhydride | 3 | 3 | 3 | 3 | 3 | 3 | | | |
| | | Aromatic skeleton acid anhydride | | | | | | | 3 | | |
| | | Polyalicyclic skeleton acid anhydride | | | | | | | | 3 | |
| | | Terpene skeleton acid anhydride | | | | | | | | | 3 |
| | | Biphenyl skeleton phenol resin | | | | | | | | | |
| | | Allyl skeleton phenol resin | | | | | | | | | |
| | | Triazine skeleton phenol resin | | | | | | | | | |
| | | Melamine skeleton phenol resin | | | | | | | | | |
| | | Isocyanurate-modified solid dispersed imidazole | 1 | 1 | 1 | 1 | 1 | 1 | 1 | 1 | 1 |
| | First inorganic filler (D) | 5-μm crushed alumina | 51 | 51 | 51 | 51 | 51 | 51 | 51 | 51 | 51 |
| | | 2-μm crushed alumina | | | | | | | | | |
| | | 6-μm crushed aluminum nitride | | | | | | | | | |
| | Organic filler (E1) | 0.1-μm particles | 3 | 3 | 3 | 3 | 3 | 3 | 3 | 3 | 3 |
| | | 0.5-μm particles | | | | | | | | | |
| | | 4-μm particles | | | | | | | | | |
| | Additive | Epoxy silane coupling agent | 1 | 1 | 1 | 1 | 1 | 1 | 1 | 1 | 1 |
| | Solvent | Methylethyl ketone | 28 | 28 | 28 | 28 | 28 | 28 | 28 | 28 | 28 |
| Amount of polymer (A) (% by weight) *1 | | | 39 | 39 | 39 | 39 | 39 | 39 | 39 | 39 | 39 |
| Amount of monomer (B) (% by weight) *1 | | | 22 | 22 | 22 | 22 | 22 | 22 | 22 | 22 | 22 |
| Amount of curing agent (C) (% by weight) *1 | | | 22 | 22 | 22 | 22 | 22 | 22 | 22 | 22 | 22 |
| Amount of first inorganic filler (D) (% by volume) *2 | | | 43 | 43 | 43 | 43 | 43 | 43 | 43 | 43 | 43 |
| Amount of filler (E) (% by volume) *2 | | | 8.2 | 8.2 | 8.2 | 8.2 | 8.2 | 8.2 | 8.2 | 8.2 | 8.2 |
| Evaluation | Handleability | | ○ | ○ | ○ | ○ | ○ | ○ | ○ | ○ | ○ |
| | Thermal conductivity (W/m•K) | | 1.4 | 1.5 | 1.4 | 1.4 | 1.5 | 1.5 | 1.4 | 1.5 | 1.5 |
| | Dielectric breakdown voltage (kV/mm) | | 79 | 81 | 78 | 80 | 83 | 84 | 82 | 83 | 85 |
| | Solder heat resistance (288℃) | | ◎ | ◎ | ◎ | ◎ | ◎ | ◎ | ◎ | ◎ | ◎ |
| | Processability | | ○ | ○ | ○ | ○ | ○ | ○ | ○ | ○ | ○ |
| | Protrusion amount in laminating press (%) | | 6.8 | 6.8 | 5.4 | 5.4 | 4.4 | 5.1 | 5.3 | 5.6 | 5.7 |
| | | | ○ | ○ | ○ | ○ | ○ | ○ | ○ | ○ | ○ |

*1 The amount in 100% by weight of all the resin components, except for the organic filler (E1), in the insulating sheet
*2 The amount in 100% by volume of the insulating sheet including the organic filler (E1)

[Table 3]

| | | | Examples | | | | Comp. Examples | | | | |
|---|---|---|---|---|---|---|---|---|---|---|---|
| | | | 19 | 20 | 21 | 22 | 1 | 2 | 3 | 4 | 5 |
| Components (parts by weight) | Polymer (A) | Bisphenol A phenoxy resin | 7 | 7 | 7 | 7 | 10 | 10 | 3 | | 7 |
| | | Highly heat-resistant phenoxy resin | | | | | | | | | |
| | | Epoxy group-containing styrene resin | | | | | | | | | |
| | Polymer other than polymer (A) | Epoxy group-containing acrylic resin | | | | | | | | 7 | |
| | Epoxy monomer (B1) | Bisphenol A liquid epoxy resin | 4 | 4 | 4 | 4 | 4 | 9 | 4 | 4 | |
| | | Bisphenol F liquid epoxy resin | | | | | | | | | |
| | | Trifunctional glycidyl diamine liquid epoxy resin | | | | | | | | | |
| | | Fluorene skeleton epoxy resin | | | | | | | | | |
| | | Naphthalene skeleton liquid epoxy resin | | | | | | | | | |
| | Oxetane monomer (B2) | Benzene-skeleton containing oxetane resin | | | | | | | | | |
| | Monomer other than monomers (B) | Hexahydrophthalate skeleton liquid epoxy resin | 2 | 2 | 2 | 2 | 2 | 1 | 2 | 2 | 2 |
| | | Bisphenol A solid epoxy resin | | | | | | | | | 4 |
| | Curing agent (C) | Alicyclic skeleton acid anhydride | | | | | 3 | 3 | 3 | 3 | 3 |
| | | Aromatic skeleton acid anhydride | | | | | | | | | |
| | | Polyalicyclic skeleton acid anhydride | | | | | | | | | |
| | | Terpene skeleton acid anhydride | | | | | | | | | |
| | | Biphenyl skeleton phenol resin | 3 | | | | | | | | |
| | | Allyl skeleton phenol resin | | 3 | | | | | | | |
| | | Triazine skeleton phenol resin | | | 3 | | | | | | |
| | | Melamine skeleton phenol resin | | | | 3 | | | | | |
| | | Isocyanurate-modified solid dispersed imidazole | 1 | 1 | 1 | 1 | 1 | 1 | 1 | 1 | 1 |
| | First inorganic filler (D) | 5-μm crushed alumina | 51 | 51 | 51 | 51 | 51 | 55 | 36 | 51 | 51 |
| | | 2-μm crushed alumina | | | | | | | | | |
| | | 6-μm crushed aluminum nitride | | | | | | | | | |
| | Organic filler (E1) | 0.1-μm particles | 3 | 3 | 3 | 3 | | 1 | 21 | 3 | 3 |
| | | 0.5-μm particles | | | | | | | | | |
| | | 4-μm particles | | | | | | | | | |
| | Additive | Epoxy silane coupling agent | 1 | 1 | 1 | 1 | 1 | 1 | 1 | 1 | 1 |
| | Solvent | Methylethyl ketone | 28 | 28 | 28 | 28 | 28 | 27 | 29 | 28 | 28 |
| Amount of polymer (A) (% by weight) *1 | | | 39 | 39 | 39 | 39 | 48 | 40 | 21 | 0 | 39 |
| Amount of monomer (B) (% by weight) *1 | | | 22 | 22 | 22 | 22 | 19 | 36 | 29 | 22 | 0 |
| Amount of curing agent (C) (% by weight) *1 | | | 22 | 22 | 22 | 22 | 19 | 16 | 29 | 22 | 22 |
| Amount of first inorganic filler (D) (% by volume) *2 | | | 43 | 43 | 43 | 43 | 43 | 48 | 24 | 43 | 43 |
| Amount of filler (E) (% by volume) *2 | | | 8.2 | 8.2 | 8.2 | 8.2 | 0 | 2.9 | 46 | 8.2 | 8.2 |
| Evaluation | Handleability | | ○ | ○ | ○ | ○ | × | ○ | ○ | × | × |
| | Thermal conductivity (W/m•K) | | 1.4 | 1.5 | 1.4 | 1.5 | 1.5 | 1.7 | 0.7 | 1.5 | 1.5 |
| | Dielectric breakdown voltage (kV/mm) | | 88 | 81 | 84 | 85 | 82 | 80 | 88 | 79 | 81 |
| | Solder heat resistance (288°C) | | ◎ | ◎ | ◎ | ◎ | ◎ | ◎ | × | × | ○ |
| | Processability | | ○ | ○ | ○ | ○ | ○ | ○ | ○ | ○ | ○ |
| | Protrusion amount in laminating press (%) | | 5.5 | 5.1 | 5.9 | 5.4 | 35 | 25 | 4.1 | 5.9 | 4.9 |
| | | | ○ | ○ | ○ | ○ | × | × | ○ | ○ | ○ |

*1 The amount in 100% by weight of all the resin components, except for the organic filler (E1), in the insulating sheet
*2 The amount in 100% by volume of the insulating sheet including the organic filler (E1)

(Examples 23 to 68 and Comparative Examples 6 to 13)

Except that the kinds and amounts of the compounds were changed as shown in the following Tables 4 to 12,

insulating materials were prepared in the same manner as in Example 1 and insulating sheets each were prepared on the PET film.

(Evaluations on insulating sheets of Examples 23 to 68 and Comparative Examples 6 to 13)

Each insulating sheet was evaluated on the aforementioned evaluation items (1) to (4) in the same manner as in Examples 1 to 22 and Comparative Examples 1 to 5. Except that the evaluation criteria of processability were changed as follows, each insulating sheet was evaluated on (5-2) processability in the same manner as in the evaluation on (5-1) processability. Further, each insulating sheet was also evaluated on evaluation items (6) to (11).

(5-2) Processability

In the same manner as in the evaluation on (5-1) processability, the processing distance at which a burr generated was measured, and the processability was evaluated on the following criteria.

[Evaluation criteria of processability]

oo (double circle): Processable for 20 m or more without a burr.
o: Processable for 5 m or more and less than 20 m without a burr.
Δ: Processable for 1 m or more and less than 5 m without a burr.
×: Processing for less than 1 m caused a burr.

(6) Glass transition temperature

The glass transition temperature of the uncured insulating sheet was measured at a temperature-rise rate of 3°C/min with a differential scanning calorie measuring apparatus "DSC220C" (product of Seiko Instruments Inc.).

(7) Self supportability

In the evaluation of the evaluation item (1) handleability, the uncured insulating sheet after peeled off from the PET sheet was prepared. Each of the four corners of this uncured insulating sheet was fixed, and thus the insulating sheet was hung in midair so that the four corners were parallel to the horizontal direction. The insulating sheet was left for 10 minutes at 23°C, and the deformation of the insulating sheet was observed. The self supportability was evaluated according to the following criteria.

[Evaluation criteria of self supportability]

o: The insulating sheet sagged downward and the sagging length (the degree of deformation) of the insulating sheet in the vertical direction was 5 cm or shorter.
Δ: The insulating sheet sagged downward and the sagging length (the degree of deformation) of the insulating sheet in the vertical direction was longer than 5 cm.
×: The insulating sheet tore.

(8) Heat dissipation capability

The insulating sheet was sandwiched between a 1-mm thick aluminum plate and a 35-μm thick electrolytic copper foil. Then, the insulating sheet was press-cured at 120°C for one hour and then at 200°C for one hour while retaining a pressure at 4 MPa with a vacuum press to prepare a copper clad laminated plate. The copper foil surface of the prepared copper clad laminated plate was pressed to a flat-surface heat generator, with the temperature controlled to be 60°C and having the same size as that of the laminated plate, at a pressure of 196 $N/cm^2$ The surface temperature of the aluminum plate was measured with a thermocouple, and the heat dissipation capability was evaluated according to the following criteria.

[Evaluation criteria of heat dissipation capability]

oo (double circle): The temperature difference between the heat generator and the surface of the aluminum plate was within 3°C.
o: The temperature difference between the heat generator and the surface of the aluminum plate was greater than 3°C and not greater than 6°C.
Δ: The temperature difference between the heat generator and the surface of the aluminum plate was greater than 6°C and not greater than 10°C.
×: The temperature difference between the heat generator and the surface of the aluminum plate was greater than 10°C.

(9) Bending modulus

A sample piece (length: 8 cm, width: 1 cm, thickness: 4 mm) was subjected to a measurement at a span of 6 cm and at a rate of 1.5 mm/min. with a universal tester RTC-1310A (product of ORIENTEC Co., Ltd.) in accordance with JIS K 7111. Thereby, the bending modulus at 25°C of the uncured insulating sheet was measured.
Then, the insulating sheet was cured at 120°C for one hour and then at 200°C for one hour to provide a cured product of the insulating sheet. In the same manner as for the uncured insulating sheet, the sample piece (length: 8 cm, width: 1 cm, thickness: 4 mm) was subjected to a measurement at a span of 6 cm and at a rate of 1.5 mm/min. with a universal tester (product of ORIENTEC Co., Ltd.) in accordance with JIS K 7111. Thus, the bending modulus at 25°C of the cured product of the insulating sheet was measured.

(10) Elastic modulus

A 2-cm diameter disc-shaped sample of the uncured insulating sheet was prepared, and the tanδ at 25°C of the uncured insulating sheet was measured by means of a rotating dynamic viscoelasticity measuring apparatus VAR-100 (product of REOLOGICA Instruments AB) with a 2-cm diameter parallel plate at an initial stress of 10 Pa, a frequency of 1 Hz, and a strain of 1% in an oscillation strain controlling mode. Further, the maximum tanδ of the insulating sheet when the uncured insulating sheet was heated from 25°C to 250°C was measured by heating the uncured insulating sheet sample from 25°C to 250°C at a heating rate of 30°C/min. under the aforementioned conditions.

(11) Reaction ratio

The prepared insulating sheet was heated to 120°C at an initial temperature of 30°C and a temperature-rise rate of 8°C/min with a differential scanning calorie measuring apparatus "DSC220C" produced by Seiko Instruments Inc., and then kept for one hour. The insulating sheet was further heated to 200°C at a temperature-rise rate of 8°C/min, and then kept for one hour. The quantity of heat generated upon curing the insulating sheet through these two steps (hereinafter, referred to as Heat quantity A) was measured.
The insulating material used for preparing the insulating sheet of the examples and the comparative examples was applied to a 50-μm thick release PET sheet so that the thickness of the insulating material was 100 μm. Then, except that the insulating material was dried for 1 hour under normal-temperature (23°C) and vacuum (0.01 atm) conditions, that is, without heating, the dried uncured insulating sheet was prepared in the same manner as in the examples and the comparative examples. The quantity of heat generated upon curing the insulating sheet through the two steps (hereinafter, referred to as Heat quantity B) was measured in the same manner as for measuring Heat quantity A. By the use of the obtained Heat quantities A and B and the following equation, the reaction ratio of the uncured insulating sheet was calculated.

$$\text{Reaction ratio (\%)} = [1 - (\text{Heat quantity A}/\text{Heat quantity B})] \times 100$$

Tables 4 to 12 show the results.
[Table 4]

| | | | Examples | | | | | | |
|---|---|---|---|---|---|---|---|---|---|
| | | | 23 | 24 | 25 | 26 | 27 | 28 | 29 |
| Components (parts by weight) | Polymer (A) | Bisphenol A phenoxy resin | 7 | 7 | 7 | 7 | 7 | 7 | 7 |
| | | Highly heat-resistant phenoxy resin | | | | | | | |
| | | Epoxy group-containing styrene resin | | | | | | | |
| | Polymer other than polymer (A) | Epoxy group-containing acrylic resin | | | | | | | |
| | Epoxy monomer (B1) | Bisphenol A liquid epoxy resin | 4 | 4 | 4 | 4 | 4 | 4 | 4 |
| | | Bisphenol F liquid epoxy resin | | | | | | | |
| | | Trifunctional glycidyl diamine liquid epoxy resin | | | | | | | |
| | | Fluorene skeleton epoxy resin | | | | | | | |
| | | Naphthalene skeleton liquid epoxy resin | | | | | | | |
| | Oxetane monomer (B2) | Benzene-skeleton containing oxetane resin | | | | | | | |
| | Monomer other than monomers (B) | Hexahydrophthalate skeleton liquid epoxy resin | 2 | 2 | 2 | 2 | 2 | 2 | 2 |
| | | Bisphenol A solid epoxy resin | | | | | | | |
| | Curing agent (C) | Alicyclic skeleton acid anhydride | 3 | 3 | 3 | 3 | 3 | 3 | 3 |
| | | Aromatic skeleton acid anhydride | | | | | | | |
| | | Polyalicyclic skeleton acid anhydride | | | | | | | |
| | | Terpene skeleton acid anhydride | | | | | | | |
| | | Biphenyl skeleton phenol resin | | | | | | | |
| | | Allyl skeleton phenol resin | | | | | | | |
| | | Triazine skeleton phenol resin | | | | | | | |
| | | Melamine skeleton phenol resin | | | | | | | |
| | | Isocyanurate-modified solid dispersed imidazole | 1 | 1 | 1 | 1 | 1 | 1 | 1 |
| | First inorganic filler (D) | Spherical alumina | 51 | 51 | 51 | 51 | 51 | 51 | 51 |
| | | 2-μm crushed alumina | | | | | | | |
| | | Synthetic magnesite | | | | | | | |
| | | Aluminum nitride | | | | | | | |
| | | Crystalline silica | | | | | | | |
| | | Silicon carbide | | | | | | | |
| | | Zinc oxide | | | | | | | |
| | | Magnesium oxide | | | | | | | |
| | Organic filler (E1) | 0.1-μm particles | 3 | | | | | | |
| | | 0.5-μm particles | | 3 | | | | | |
| | | 4-μm particles | | | 3 | | | | |
| | Second inorganic filler (E2) | Mica | | | | 3 | | | |
| | | Talc | | | | | 3 | | |
| | | Boron nitride | | | | | | 3 | |
| | | Clay | | | | | | | 3 |
| | | Kaolin | | | | | | | |
| | | Aluminum hydroxide | | | | | | | |
| | | Magnesium hydroxide | | | | | | | |
| | | Calcium carbonate | | | | | | | |
| | | Diatom earth | | | | | | | |
| | Dispersant (G) | Acrylic dispersant | | | | | | | |
| | | Polyether dispersant | | | | | | | |
| | Additive | Epoxy silane coupling agent | 1 | 1 | 1 | 1 | 1 | 1 | 1 |
| | Solvent | Methylethyl ketone | 28 | 28 | 28 | 28 | 28 | 28 | 28 |
| Amount of polymer (A) (% by weight) *1 | | | 39 | 39 | 39 | 39 | 39 | 39 | 39 |
| Amount of monomer (B) (% by weight) *1 | | | 22 | 22 | 22 | 22 | 22 | 22 | 22 |
| Amount of curing agent (C) (% by weight) *1 | | | 22 | 22 | 22 | 22 | 22 | 22 | 22 |
| Amount of first inorganic filler (D) (% by volume) *2 | | | 43 | 43 | 43 | 45 | 45 | 45 | 45 |
| Amount of substance (E) (% by volume) *2 | | | 8.2 | 8.2 | 8.2 | 3.4 | 3.8 | 4.5 | 3.7 |
| Left-hand value of the formula (X) | | | - | - | - | 5.50 | 5.41 | 5.43 | 5.46 |
| Evaluation | Handleability | | ○ | ○ | ○ | ○ | ○ | ○ | ○ |
| | Thermal conductivity (W/m•K) | | 1.5 | 1.5 | 1.5 | 1.9 | 2.1 | 2.6 | 1.8 |
| | Dielectric breakdown voltage (kV/mm) | | 81 | 82 | 80 | 102 | 82 | 86 | 110 |
| | Solder heat resistance (288℃) | | ◎ | ◎ | ◎ | ◎ | ◎ | ◎ | ◎ |
| | Processability | | ◎ | ◎ | ◎ | ○ | ◎ | ◎ | ◎ |
| | Protrusion amount in laminating press | | ○ | ○ | ○ | ○ | ○ | ○ | ○ |
| | Glass transition temperature (℃) | | 10 | 9 | 11 | 9 | 8 | 7 | 9 |
| | Self supportability | | ○ | ○ | ○ | ○ | ○ | ○ | ○ |
| | Heat dissipation capability | | ◎ | ◎ | ◎ | ◎ | ◎ | ◎ | ◎ |
| | Bending modulus of uncured insulating sheet at 25℃ (MPa) | | 40 | 38 | 35 | 100 | 70 | 90 | 120 |
| | Bending modulus of cured product of insulating sheet at 25℃ (MPa) | | 8000 | 7500 | 7400 | 14000 | 12000 | 15000 | 18000 |
| | tan$\delta$ of uncured insulating sheet at 25℃ | | 0.8 | 0.9 | 1 | 0.3 | 0.5 | 0.4 | 0.3 |
| | Maximum tan$\delta$ of uncured insulating sheet at 25 to 250℃ | | 1.9 | 2.3 | 2.6 | 1.4 | 1.7 | 1.4 | 1.3 |
| | Reaction ratio (%) | | 7 | 8 | 7 | 7 | 8 | 6 | 9 |

*1 The amount in 100% by weight of all the resin components, except for the organic filler (E1), in the insulating sheet

*2 The amount in 100% by volume of the insulating sheet including the organic filler (E1)

[Table 5]

| | | | Examples | | | | | | |
|---|---|---|---|---|---|---|---|---|---|
| | | | 30 | 31 | 32 | 33 | 34 | 35 | 36 |
| Components (parts by weight) | Polymer (A) | Bisphenol A phenoxy resin | 7 | 7 | 7 | 7 | 7 | 7 | 7 |
| | | Highly heat-resistant phenoxy resin | | | | | | | |
| | | Epoxy group-containing styrene resin | | | | | | | |
| | Polymer other than polymer (A) | Epoxy group-containing acrylic resin | | | | | | | |
| | Epoxy monomer (B1) | Bisphenol A liquid epoxy resin | 4 | 4 | 4 | 4 | 4 | 4 | 4 |
| | | Bisphenol F liquid epoxy resin | | | | | | | |
| | | Trifunctional glycidyl diamine liquid epoxy resin | | | | | | | |
| | | Fluorene skeleton epoxy resin | | | | | | | |
| | | Naphthalene skeleton liquid epoxy resin | | | | | | | |
| | Oxetane monomer (B2) | Benzene-skeleton containing oxetane resin | | | | | | | |
| | Monomer other than monomers (B) | Hexahydrophthalate skeleton liquid epoxy resin | 2 | 2 | 2 | 2 | 2 | 2 | 2 |
| | | Bisphenol A solid epoxy resin | | | | | | | |
| | Curing agent (C) | Alicyclic skeleton acid anhydride | 3 | 3 | 3 | 3 | 3 | 3 | 3 |
| | | Aromatic skeleton acid anhydride | | | | | | | |
| | | Polyalicyclic skeleton acid anhydride | | | | | | | |
| | | Terpene skeleton acid anhydride | | | | | | | |
| | | Biphenyl skeleton phenol resin | | | | | | | |
| | | Allyl skeleton phenol resin | | | | | | | |
| | | Triazine skeleton phenol resin | | | | | | | |
| | | Melamine skeleton phenol resin | | | | | | | |
| | | Isocyanurate-modified solid dispersed imidazole | 1 | 1 | 1 | 1 | 1 | 1 | 1 |
| | First inorganic filler (D) | Spherical alumina | 51 | 51 | 51 | 51 | 51 | | |
| | | 2-μm crushed alumina | | | | | | 51 | |
| | | Synthetic magnesite | | | | | | | 51 |
| | | Aluminum nitride | | | | | | | |
| | | Crystalline silica | | | | | | | |
| | | Silicon carbide | | | | | | | |
| | | Zinc oxide | | | | | | | |
| | | Magnesium oxide | | | | | | | |
| | Organic filler (E1) | 0.1-μm particles | | | | | | | |
| | | 0.5-μm particles | | | | | | | |
| | | 4-μm particles | | | | | | | |
| | Second inorganic filler (E2) | Mica | | | | | | | |
| | | Talc | | | | | | 3 | 3 |
| | | Boron nitride | | | | | | | |
| | | Clay | | | | | | | |
| | | Kaolin | 3 | | | | | | |
| | | Aluminum hydroxide | | 3 | | | | | |
| | | Magnesium hydroxide | | | 3 | | | | |
| | | Calcium carbonate | | | | 3 | | | |
| | | Diatom earth | | | | | 3 | | |
| | Dispersant (G) | Acrylic dispersant | | | | | | | |
| | | Polyether dispersant | | | | | | | |
| | Additive | Epoxy silane coupling agent | 1 | 1 | 1 | 1 | 1 | 1 | 1 |
| | Solvent | Methylethyl ketone | 28 | 28 | 28 | 28 | 28 | 28 | 28 |
| Amount of polymer (A) (% by weight) *1 | | | 39 | 39 | 39 | 39 | 39 | 39 | 39 |
| Amount of monomer (B) (% by weight) *1 | | | 22 | 22 | 22 | 22 | 22 | 22 | 22 |
| Amount of curing agent (C) (% by weight) *1 | | | 22 | 22 | 22 | 22 | 22 | 22 | 22 |
| Amount of first inorganic filler (D) (% by volume) *2 | | | 45 | 45 | 45 | 45 | 44 | 45 | 51 |
| Amount of substance (E) (% by volume) *2 | | | 3.8 | 4.2 | 4.3 | 3.9 | 4.6 | 3.8 | 3.4 |
| Left-hand value of the formula (X) | | | 5.48 | 5.48 | 5.46 | 5.48 | 5.42 | 5.41 | 1.83 |
| Evaluation | Handleability | | ○ | ○ | ○ | ○ | ○ | ○ | ○ |
| | Thermal conductivity (W/m•K) | | 1.7 | 2 | 2.3 | 1.6 | 1.4 | 2.2 | 2.3 |
| | Dielectric breakdown voltage (kV/mm) | | 90 | 78 | 80 | 80 | 60 | 86 | 72 |
| | Solder heat resistance (288℃) | | ◎ | ◎ | ○ | ◎ | ○ | ◎ | ◎ |
| | Processability | | ◎ | ◎ | ◎ | ◎ | ◎ | ◎ | ◎ |
| | Protrusion amount in laminating press | | ○ | ○ | ○ | ○ | ○ | ○ | ○ |
| | Glass transition temperature (℃) | | 8 | 7 | 6 | 8 | 7 | 8 | 7 |
| | Self supportability | | ○ | ○ | ○ | ○ | ○ | ○ | ○ |
| | Heat dissipation capability | | ◎ | ◎ | ◎ | ◎ | ◎ | ◎ | ◎ |
| | Bending modulus of uncured insulating sheet at 25℃ (MPa) | | 80 | 60 | 70 | 50 | 100 | 130 | 120 |
| | Bending modulus of cured product of insulating sheet at 25℃ (MPa) | | 13000 | 10000 | 11000 | 9000 | 15000 | 18000 | 18000 |
| | tan$\delta$ of uncured insulating sheet at 25℃ | | 0.5 | 0.7 | 0.6 | 0.7 | 0.3 | 0.3 | 0.3 |
| | Maximum tan$\delta$ of uncured insulating sheet at 25 to 250℃ | | 1.5 | 1.8 | 1.7 | 1.8 | 1.4 | 1.4 | 1.3 |
| | Reaction ratio (%) | | 8 | 7 | 6 | 7 | 8 | 6 | 8 |

*1 The amount in 100% by weight of all the resin components, except for the organic filler (E1), in the insulating sheet

*2 The amount in 100% by volume of the insulating sheet including the organic filler (E1)

[Table 6]

| | | | Examples | | | | | | |
|---|---|---|---|---|---|---|---|---|---|
| | | | 37 | 38 | 39 | 40 | 41 | 42 | 43 |
| Components (parts by weight) | Polymer (A) | Bisphenol A phenoxy resin | 7 | 7 | 10 | 7 | 7 | 7 | 7 |
| | | Highly heat-resistant phenoxy resin | | | | | | | |
| | | Epoxy group-containing styrene resin | | | | | | | |
| | Polymer other than polymer (A) | Epoxy group-containing acrylic resin | | | | | | | |
| | Epoxy monomer (B1) | Bisphenol A liquid epoxy resin | 4 | 4 | 6 | 4 | 4 | 4 | 4 |
| | | Bisphenol F liquid epoxy resin | | | | | | | |
| | | Trifunctional glycidyl diamine liquid epoxy resin | | | | | | | |
| | | Fluorene skeleton epoxy resin | | | | | | | |
| | | Naphthalene skeleton liquid epoxy resin | | | | | | | |
| | Oxetane monomer (B2) | Benzene-skeleton containing oxetane resin | | | | | | | |
| | Monomer other than monomers (B) | Hexahydrophthalate skeleton liquid epoxy resin | 2 | 2 | 3 | 2 | 2 | 2 | 2 |
| | | Bisphenol A solid epoxy resin | | | | | | | |
| | Curing agent (C) | Alicyclic skeleton acid anhydride | 3 | 3 | 4 | 3 | 3 | 3 | 3 |
| | | Aromatic skeleton acid anhydride | | | | | | | |
| | | Polyalicyclic skeleton acid anhydride | | | | | | | |
| | | Terpene skeleton acid anhydride | | | | | | | |
| | | Biphenyl skeleton phenol resin | | | | | | | |
| | | Allyl skeleton phenol resin | | | | | | | |
| | | Triazine skeleton phenol resin | | | | | | | |
| | | Melamine skeleton phenol resin | | | | | | | |
| | | Isocyanurate-modified solid dispersed imidazole | 1 | 1 | 2 | 1 | 1 | 1 | 1 |
| | First inorganic filler (D) | Spherical alumina | | | | | | | |
| | | 2-μm crushed alumina | | | | | | 31 | |
| | | Synthetic magnesite | | | | | | | |
| | | Aluminum nitride | 51 | | | | | | 24 |
| | | Crystalline silica | | 51 | | | | | |
| | | Silicon carbide | | | 42 | | | | |
| | | Zinc oxide | | | | 51 | | | |
| | | Magnesium oxide | | | | | 51 | | |
| | Organic filler (E1) | 0.1-μm particles | | | | | | | |
| | | 0.5-μm particles | | | | | | | |
| | | 4-μm particles | | | | | | | |
| | Second inorganic filler (E2) | Mica | | | | | | | |
| | | Talc | 3 | 3 | 3 | 3 | 3 | 23 | 30 |
| | | Boron nitride | | | | | | | |
| | | Clay | | | | | | | |
| | | Kaolin | | | | | | | |
| | | Aluminum hydroxide | | | | | | | |
| | | Magnesium hydroxide | | | | | | | |
| | | Calcium carbonate | | | | | | | |
| | | Diatom earth | | | | | | | |
| | Dispersant (G) | Acrylic dispersant | | | | | | | |
| | | Polyether dispersant | | | | | | | |
| | Additive | Epoxy silane coupling agent | 1 | 1 | 2 | 1 | 1 | 1 | 1 |
| | Solvent | Methylethyl ketone | 28 | 28 | 28 | 28 | 28 | 28 | 28 |
| Amount of polymer (A) (% by weight) *1 | | | 39 | 39 | 37 | 39 | 39 | 39 | 39 |
| Amount of monomer (B) (% by weight) *1 | | | 22 | 22 | 22 | 22 | 22 | 22 | 22 |
| Amount of curing agent (C) (% by weight) *1 | | | 22 | 22 | 22 | 22 | 22 | 22 | 22 |
| Amount of first inorganic filler (D) (% by volume) *2 | | | 49 | 54 | 36 | 37 | 49 | 25 | 22 |
| Amount of substance (E) (% by volume) *2 | | | 3.5 | 3.1 | 3 | 4.4 | 3.5 | 27 | 33.3 |
| Left-hand value of the formula (X) | | | 5.43 | 3.84 | 4.71 | 1.87 | 2.98 | 3.27 | 2.73 |
| Evaluation | Handleability | | ○ | ○ | ○ | ○ | ○ | ○ | ○ |
| | Thermal conductivity (W/m•K) | | 3.1 | 1 | 3 | 2.6 | 2.4 | 0.9 | 1.1 |
| | Dielectric breakdown voltage (kV/mm) | | 70 | 80 | 48 | 56 | 60 | 48 | 42 |
| | Solder heat resistance (288℃) | | ◎ | ◎ | ◎ | ◎ | ◎ | ◎ | ◎ |
| | Processability | | ◎ | ◎ | ◎ | ◎ | ◎ | ◎ | ◎ |
| | Protrusion amount in laminating press | | ○ | ○ | ○ | ○ | ○ | ○ | ○ |
| | Glass transition temperature (℃) | | 6 | 5 | 8 | 7 | 7 | 9 | 8 |
| | Self supportability | | ○ | ○ | ○ | ○ | ○ | ○ | ○ |
| | Heat dissipation capability | | ◎ | ○ | ◎ | ◎ | ◎ | ○ | ○ |
| | Bending modulus of uncured insulating sheet at 25℃ (MPa) | | 70 | 100 | 150 | 130 | 110 | 300 | 400 |
| | Bending modulus of cured product of insulating sheet at 25℃ (MPa) | | 10000 | 14000 | 20000 | 17000 | 15000 | 32000 | 38000 |
| | tan$\delta$ of uncured insulating sheet at 25℃ | | 0.8 | 0.3 | 0.2 | 0.4 | 0.3 | 0.1 | 0.1 |
| | Maximum tan$\delta$ of uncured insulating sheet at 25 to 250℃ | | 1.8 | 1.4 | 1.2 | 1.3 | 1.4 | 1.1 | 1 |
| | Reaction ratio (%) | | 10 | 6 | 7 | 8 | 7 | 7 | 8 |

*1 The amount in 100% by weight of all the resin components, except for the organic filler (E1), in the insulating sheet
*2 The amount in 100% by volume of the insulating sheet including the organic filler (E1)

[Table 7]

| | | | Examples | | | | | | |
|---|---|---|---|---|---|---|---|---|---|
| | | | 44 | 45 | 46 | 47 | 48 | 49 | 50 |
| Components (parts by weight) | Polymer (A) | Bisphenol A phenoxy resin | 6 | | | 7 | 7 | 7 | 7 |
| | | Highly heat-resistant phenoxy resin | | 7 | | | | | |
| | | Epoxy group-containing styrene resin | | | 7 | | | | |
| | Polymer other than polymer (A) | Epoxy group-containing acrylic resin | | | | | | | |
| | Epoxy monomer (B1) | Bisphenol A liquid epoxy resin | 3 | 4 | 4 | | | | |
| | | Bisphenol F liquid epoxy resin | | | | 4 | | | |
| | | Trifunctional glycidyl diamine liquid epoxy resin | | | | | 4 | | |
| | | Fluorene skeleton epoxy resin | | | | | | 4 | |
| | | Naphthalene skeleton liquid epoxy resin | | | | | | | 4 |
| | Oxetane monomer (B2) | Benzene-skeleton containing oxetane resin | | | | | | | |
| | Monomer other than monomers (B) | Hexahydrophthalate skeleton liquid epoxy resin | 1 | 2 | 2 | 2 | 2 | 2 | 2 |
| | | Bisphenol A solid epoxy resin | | | | | | | |
| | Curing agent (C) | Alicyclic skeleton acid anhydride | 2 | 3 | 3 | 3 | 3 | 3 | 3 |
| | | Aromatic skeleton acid anhydride | | | | | | | |
| | | Polyalicyclic skeleton acid anhydride | | | | | | | |
| | | Terpene skeleton acid anhydride | | | | | | | |
| | | Biphenyl skeleton phenol resin | | | | | | | |
| | | Allyl skeleton phenol resin | | | | | | | |
| | | Triazine skeleton phenol resin | | | | | | | |
| | | Melamine skeleton phenol resin | | | | | | | |
| | | Isocyanurate-modified solid dispersed imidazole | 1 | 1 | 1 | 1 | 1 | 1 | 1 |
| | First inorganic filler (D) | Spherical alumina | | | | | | | |
| | | 2-μm crushed alumina | | 51 | 51 | 51 | 51 | 51 | 51 |
| | | Synthetic magnesite | | | | | | | |
| | | Aluminum nitride | | | | | | | |
| | | Crystalline silica | | | | | | | |
| | | Silicon carbide | | | | | | | |
| | | Zinc oxide | | | | | | | |
| | | Magnesium oxide | 57 | | | | | | |
| | Organic filler (E1) | 0.1-μm particles | | | | | | | |
| | | 0.5-μm particles | | | | | | | |
| | | 4-μm particles | | | | | | | |
| | Second inorganic filler (E2) | Mica | | | | | | | |
| | | Talc | 1 | 3 | 3 | 3 | 3 | 3 | 3 |
| | | Boron nitride | | | | | | | |
| | | Clay | | | | | | | |
| | | Kaolin | | | | | | | |
| | | Aluminum hydroxide | | | | | | | |
| | | Magnesium hydroxide | | | | | | | |
| | | Calcium carbonate | | | | | | | |
| | | Diatom earth | | | | | | | |
| | Dispersant (G) | Acrylic dispersant | | | | | | | |
| | | Polyether dispersant | | | | | | | |
| | Additive | Epoxy silane coupling agent | 1 | 1 | 1 | 1 | 1 | 1 | 1 |
| | Solvent | Methylethyl ketone | 28 | 28 | 28 | 28 | 28 | 28 | 28 |
| Amount of polymer (A) (% by weight) *1 | | | 43 | 39 | 39 | 39 | 39 | 39 | 39 |
| Amount of monomer (B) (% by weight) *1 | | | 21 | 22 | 22 | 22 | 22 | 22 | 22 |
| Amount of curing agent (C) (% by weight) *1 | | | 21 | 22 | 22 | 22 | 22 | 22 | 22 |
| Amount of first inorganic filler (D) (% by volume) *2 | | | 59 | 45 | 45 | 45 | 45 | 45 | 45 |
| Amount of substance (E) (% by volume) *2 | | | 1.3 | 3.8 | 3.8 | 3.8 | 3.8 | 3.8 | 3.8 |
| Left-hand value of the formula (X) | | | 3.55 | 5.41 | 5.41 | 5.41 | 5.41 | 5.41 | 5.41 |
| Evaluation | Handleability | | ○ | ○ | ○ | ○ | ○ | ○ | ○ |
| | Thermal conductivity (W/m•K) | | 3.8 | 2.3 | 2.2 | 2.1 | 2.2 | 2.3 | 2.3 |
| | Dielectric breakdown voltage (kV/mm) | | 52 | 92 | 100 | 66 | 72 | 99 | 110 |
| | Solder heat resistance (288℃) | | ◎ | ◎ | ◎ | ◎ | ◎ | ◎ | ◎ |
| | Processability | | ◎ | ◎ | ◎ | ◎ | ◎ | ◎ | ◎ |
| | Protrusion amount in laminating press | | ○ | ○ | ○ | ○ | ○ | ○ | ○ |
| | Glass transition temperature (℃) | | 7 | 8 | 8 | 5 | 5 | 10 | 6 |
| | Self supportability | | ○ | ○ | ○ | ○ | ○ | ○ | ○ |
| | Heat dissipation capability | | ◎ | ◎ | ◎ | ◎ | ◎ | ◎ | ◎ |
| | Bending modulus of uncured insulating sheet at 25℃ (MPa) | | 350 | 140 | 130 | 80 | 90 | 140 | 100 |
| | Bending modulus of cured product of insulating sheet at 25℃ (MPa) | | 34000 | 19000 | 18000 | 13000 | 13000 | 20000 | 14000 |
| | tan$\delta$ of uncured insulating sheet at 25℃ | | 0.1 | 0.3 | 0.3 | 0.5 | 0.5 | 0.2 | 0.3 |
| | Maximum tan$\delta$ of uncured insulating sheet at 25 to 250℃ | | 1.1 | 1.4 | 1.4 | 1.7 | 1.6 | 1.3 | 1.4 |
| | Reaction ratio (%) | | 8 | 6 | 7 | 7 | 8 | 7 | 7 |

*1 The amount in 100% by weight of all the resin components, except for the organic filler (E1), in the insulating sheet
*2 The amount in 100% by volume of the insulating sheet including the organic filler (E1)

[Table 8]

| | | | Examples | | | | | | |
|---|---|---|---|---|---|---|---|---|---|
| | | | 51 | 52 | 53 | 54 | 55 | 56 | 57 |
| Components (parts by weight) | Polymer (A) | Bisphenol A phenoxy resin | 7 | 7 | 7 | 7 | 7 | 7 | 7 |
| | | Highly heat-resistant phenoxy resin | | | | | | | |
| | | Epoxy group-containing styrene resin | | | | | | | |
| | Polymer other than polymer (A) | Epoxy group-containing acrylic resin | | | | | | | |
| | Epoxy monomer (B1) | Bisphenol A liquid epoxy resin | | 4 | 4 | 4 | 4 | 4 | 4 |
| | | Bisphenol F liquid epoxy resin | | | | | | | |
| | | Trifunctional glycidyl diamine liquid epoxy resin | | | | | | | |
| | | Fluorene skeleton epoxy resin | | | | | | | |
| | | Naphthalene skeleton liquid epoxy resin | | | | | | | |
| | Oxetane monomer (B2) | Benzene-skeleton containing oxetane resin | 4 | | | | | | |
| | Monomer other than monomers (B) | Hexahydrophthalate skeleton liquid epoxy resin | 2 | 2 | 2 | 2 | 2 | 2 | 2 |
| | | Bisphenol A solid epoxy resin | | | | | | | |
| | Curing agent (C) | Alicyclic skeleton acid anhydride | 3 | | | | | | |
| | | Aromatic skeleton acid anhydride | | 3 | | | | | |
| | | Polyalicyclic skeleton acid anhydride | | | 3 | | | | |
| | | Terpene skeleton acid anhydride | | | | 3 | | | |
| | | Biphenyl skeleton phenol resin | | | | | 3 | | |
| | | Allyl skeleton phenol resin | | | | | | 3 | |
| | | Triazine skeleton phenol resin | | | | | | | 3 |
| | | Melamine skeleton phenol resin | | | | | | | |
| | | Isocyanurate-modified solid dispersed imidazole | 1 | 1 | 1 | 1 | 1 | 1 | 1 |
| | First inorganic filler (D) | Spherical alumina | | | | | | | |
| | | 2-μm crushed alumina | 51 | 51 | 51 | 51 | 51 | 51 | 51 |
| | | Synthetic magnesite | | | | | | | |
| | | Aluminum nitride | | | | | | | |
| | | Crystalline silica | | | | | | | |
| | | Silicon carbide | | | | | | | |
| | | Zinc oxide | | | | | | | |
| | | Magnesium oxide | | | | | | | |
| | Organic filler (E1) | 0.1-μm particles | | | | | | | |
| | | 0.5-μm particles | | | | | | | |
| | | 4-μm particles | | | | | | | |
| | Second inorganic filler (E2) | Mica | | | | | | | |
| | | Talc | 3 | 3 | 3 | 3 | 3 | 3 | 3 |
| | | Boron nitride | | | | | | | |
| | | Clay | | | | | | | |
| | | Kaolin | | | | | | | |
| | | Aluminum hydroxide | | | | | | | |
| | | Magnesium hydroxide | | | | | | | |
| | | Calcium carbonate | | | | | | | |
| | | Diatom earth | | | | | | | |
| | Dispersant (G) | Acrylic dispersant | | | | | | | |
| | | Polyether dispersant | | | | | | | |
| | Additive | Epoxy silane coupling agent | 1 | 1 | 1 | 1 | 1 | 1 | 1 |
| | Solvent | Methylethyl ketone | 28 | 28 | 28 | 28 | 28 | 28 | 28 |
| Amount of polymer (A) (% by weight) *1 | | | 39 | 39 | 39 | 39 | 39 | 39 | 39 |
| Amount of monomer (B) (% by weight) *1 | | | 22 | 22 | 22 | 22 | 22 | 22 | 22 |
| Amount of curing agent (C) (% by weight) *1 | | | 22 | 22 | 22 | 22 | 22 | 22 | 22 |
| Amount of first inorganic filler (D) (% by volume) *2 | | | 45 | 45 | 45 | 45 | 45 | 45 | 45 |
| Amount of substance (E) (% by volume) *2 | | | 3.8 | 3.8 | 3.8 | 3.8 | 3.8 | 3.8 | 3.8 |
| Left-hand value of the formula (X) | | | 5.41 | 5.41 | 5.41 | 5.41 | 5.41 | 5.41 | 5.41 |
| Evaluation | Handleability | | ○ | ○ | ○ | ○ | ○ | ○ | ○ |
| | Thermal conductivity (W/m•K) | | 2.1 | 2.1 | 2.2 | 2.2 | 2.1 | 2.3 | 2.3 |
| | Dielectric breakdown voltage (kV/mm) | | 80 | 82 | 90 | 92 | 88 | 56 | 80 |
| | Solder heat resistance (288°C) | | ◎ | ◎ | ◎ | ◎ | ◎ | ◎ | ◎ |
| | Processability | | ◎ | ◎ | ◎ | ◎ | ◎ | ◎ | ◎ |
| | Protrusion amount in laminating press | | ○ | ○ | ○ | ○ | ○ | ○ | ○ |
| | Glass transition temperature (°C) | | 4 | 11 | 6 | 5 | 15 | 3 | 7 |
| | Self supportability | | ○ | ○ | ○ | ○ | ○ | ○ | ○ |
| | Heat dissipation capability | | ◎ | ◎ | ◎ | ◎ | ◎ | ◎ | ◎ |
| | Bending modulus of uncured insulating sheet at 25°C (MPa) | | 100 | 180 | 90 | 80 | 220 | 90 | 150 |
| | Bending modulus of cured product of insulating sheet at 25°C (MPa) | | 14000 | 22000 | 13000 | 12000 | 24000 | 13000 | 20000 |
| | tan$\delta$ of uncured insulating sheet at 25°C | | 0.3 | 0.2 | 0.5 | 0.4 | 0.2 | 0.5 | 0.3 |
| | Maximum tan$\delta$ of uncured insulating sheet at 25 to 250°C | | 1.3 | 1.2 | 1.7 | 2 | 1.2 | 1.6 | 1.3 |
| | Reaction ratio (%) | | 5 | 8 | 5 | 6 | 9 | 7 | 8 |

*1 The amount in 100% by weight of all the resin components, except for the organic filler (E1), in the insulating sheet

*2 The amount in 100% by volume of the insulating sheet including the organic filler (E1)

[Table 9]

| | | | Examples | | | | | |
|---|---|---|---|---|---|---|---|---|
| | | | 58 | 59 | 60 | 61 | 62 | 63 |
| Components (parts by weight) | Polymer (A) | Bisphenol A phenoxy resin | 7 | 4 | 10 | 6 | 6 | 6 |
| | | Highly heat-resistant phenoxy resin | | | | | | |
| | | Epoxy group-containing styrene resin | | | | | | |
| | Polymer other than polymer (A) | Epoxy group-containing acrylic resin | | | | | | |
| | Epoxy monomer (B1) | Bisphenol A liquid epoxy resin | 4 | 10 | 2 | 4 | 4 | 3 |
| | | Bisphenol F liquid epoxy resin | | | | | | |
| | | Trifunctional glycidyl diamine liquid epoxy resin | | | | | | |
| | | Fluorene skeleton epoxy resin | | | | | | |
| | | Naphthalene skeleton liquid epoxy resin | | | | | | |
| | Oxetane monomer (B2) | Benzene-skeleton containing oxetane resin | | | | | | |
| | Monomer other than monomers (B) | Hexahydrophthalate skeleton liquid epoxy resin | 2 | | | 2 | 2 | 2 |
| | | Bisphenol A solid epoxy resin | | | | | | |
| | Curing agent (C) | Alicyclic skeleton acid anhydride | | 2 | 3 | 3 | 3 | 3 |
| | | Aromatic skeleton acid anhydride | | | | | | |
| | | Polyalicyclic skeleton acid anhydride | | | | | | |
| | | Terpene skeleton acid anhydride | | | | | | |
| | | Biphenyl skeleton phenol resin | | | | | | |
| | | Allyl skeleton phenol resin | | | | | | |
| | | Triazine skeleton phenol resin | | | | | | |
| | | Melamine skeleton phenol resin | 3 | | | | | |
| | | Isocyanurate-modified solid dispersed imidazole | 1 | 1 | 2 | 1 | 1 | 1 |
| | First inorganic filler (D) | Spherical alumina | | | | | | |
| | | 2-μm crushed alumina | 51 | 51 | 51 | 51 | 51 | 53 |
| | | Synthetic magnesite | | | | | | |
| | | Aluminum nitride | | | | | | |
| | | Crystalline silica | | | | | | |
| | | Silicon carbide | | | | | | |
| | | Zinc oxide | | | | | | |
| | | Magnesium oxide | | | | | | |
| | Organic filler (E1) | 0.1-μm particles | | | | | | |
| | | 0.5-μm particles | | | | | | |
| | | 4-μm particles | | | | | | |
| | Second inorganic filler (E2) | Mica | | | | | | |
| | | Talc | 3 | 3 | 3 | 3 | 3 | |
| | | Boron nitride | | | | | | |
| | | Clay | | | | | | |
| | | Kaolin | | | | | | |
| | | Aluminum hydroxide | | | | | | |
| | | Magnesium hydroxide | | | | | | |
| | | Calcium carbonate | | | | | | 3 |
| | | Diatom earth | | | | | | |
| | Dispersant (G) | Acrylic dispersant | | | | 1 | | |
| | | Polyether dispersant | | | | | 1 | |
| | Additive | Epoxy silane coupling agent | 1 | 1 | 1 | 1 | 1 | 1 |
| | Solvent | Methylethyl ketone | 28 | 28 | 28 | 28 | 28 | 28 |
| Amount of polymer (A) (% by weight) *1 | | | 39 | 22 | 56 | 33 | 33 | 38 |
| Amount of monomer (B) (% by weight) *1 | | | 22 | 56 | 11 | 22 | 22 | 19 |
| Amount of curing agent (C) (% by weight) *1 | | | 22 | 17 | 28 | 22 | 22 | 25 |
| Amount of first inorganic filler (D) (% by volume) *2 | | | 45 | 45 | 45 | 45 | 45 | 48 |
| Amount of substance (E) (% by volume) *2 | | | 3.8 | 3.8 | 3.8 | 3.8 | 3.8 | 4.1 |
| Left-hand value of the formula (X) | | | 5.41 | 5.4 | 5.4 | 5.4 | 5.4 | 5.93 |
| Evaluation | Handleability | | ○ | ○ | ○ | ○ | ○ | ○ |
| | Thermal conductivity (W/m•K) | | 2.2 | 2.1 | 2 | 2.3 | 2.3 | 1.6 |
| | Dielectric breakdown voltage (kV/mm) | | 82 | 88 | 72 | 120 | 110 | 76 |
| | Solder heat resistance (288℃) | | ◎ | ◎ | ◎ | ◎ | ◎ | ◎ |
| | Processability | | ◎ | ◎ | ◎ | ◎ | ◎ | ○ |
| | Protrusion amount in laminating press | | ○ | ○ | ○ | ○ | ○ | ○ |
| | Glass transition temperature (℃) | | 8 | 3 | 16 | 7 | 7 | 8.0 |
| | Self supportability | | ○ | ○ | ○ | ○ | ○ | ○ |
| | Heat dissipation capability | | ◎ | ◎ | ○ | ◎ | ◎ | ◎ |
| | Bending modulus of uncured insulating sheet at 25℃ (MPa) | | 160 | 20 | 600 | 100 | 100 | 70 |
| | Bending modulus of cured product of insulating sheet at 25℃ (MPa) | | 21000 | 5000 | 33000 | 14000 | 14000 | 10000 |
| | tan$\delta$ of uncured insulating sheet at 25℃ | | 0.2 | 0.5 | 0.1 | 0.3 | 0.3 | 0.6 |
| | Maximum tan$\delta$ of uncured insulating sheet at 25 to 250℃ | | 1.2 | 4 | 1.1 | 1.3 | 1.3 | 1.7 |
| | Reaction ratio (%) | | 9 | 9 | 7 | 7 | 7 | 7 |

*1 The amount in 100% by weight of all the resin components, except for the organic filler (E1), in the insulating sheet
*2 The amount in 100% by volume of the insulating sheet including the organic filler (E1)

[Table 10]

| | | | Examples | | | | |
|---|---|---|---|---|---|---|---|
| | | | 64 | 65 | 66 | 67 | 68 |
| Components (parts by weight) | Polymer (A) | Bisphenol A phenoxy resin | 7 | 7 | | | |
| | | Highly heat-resistant phenoxy resin | | | | | |
| | | Epoxy group-containing styrene resin | | | | | |
| | | Carboxyl-group containing acrylic resin | | | 7 | | |
| | | Sulfonic-acid-group containing styrene resin | | | | 7 | |
| | | Phosphate-group containing acrylic resin | | | | | 7 |
| | Polymer other than polymer (A) | Epoxy group-containing acrylic resin | | | | | |
| | Epoxy monomer (B1) | Bisphenol A liquid epoxy resin | | | 4 | 4 | 4 |
| | | Bisphenol F liquid epoxy resin | | | | | |
| | | Trifunctional glycidyl diamine liquid epoxy resin | | | | | |
| | | Fluorene skeleton epoxy resin | | | | | |
| | | Naphthalene skeleton liquid epoxy resin | | | | | |
| | | Distilled bisphenol A liquid epoxy resin | 4 | | | | |
| | | Distilled bisphenol F liquid epoxy resin | | 4 | | | |
| | Oxetane monomer (B2) | Benzene-skeleton containing oxetane resin | | | | | |
| | Monomer other than monomers (B) | Hexahydrophthalate skeleton liquid epoxy resin | 2 | 2 | 2 | 2 | 2 |
| | | Bisphenol A solid epoxy resin | | | | | |
| | Curing agent (C) | Alicyclic skeleton acid anhydride | 3 | 3 | 3 | 3 | 3 |
| | | Aromatic skeleton acid anhydride | | | | | |
| | | Polyalicyclic skeleton acid anhydride | | | | | |
| | | Terpene skeleton acid anhydride | | | | | |
| | | Biphenyl skeleton phenol resin | | | | | |
| | | Allyl skeleton phenol resin | | | | | |
| | | Triazine skeleton phenol resin | | | | | |
| | | Melamine skeleton phenol resin | | | | | |
| | | Isocyanurate-modified solid dispersed imidazole | 1 | 1 | 1 | 1 | 1 |
| | First inorganic filler (D) | Spherical alumina | | | | | |
| | | 2-μm crushed alumina | 51 | 51 | 51 | 51 | 51 |
| | | Synthetic magnesite | | | | | |
| | | Aluminum nitride | | | | | |
| | | Crystalline silica | | | | | |
| | | Silicon carbide | | | | | |
| | | Zinc oxide | | | | | |
| | | Magnesium oxide | | | | | |
| | Organic filler (E1) | 0.1-μm particles | | | | | |
| | | 0.5-μm particles | | | | | |
| | | 4-μm particles | | | | | |
| | Second inorganic filler (E2) | Mica | | | | | |
| | | Talc | 3 | 3 | 3 | 3 | 3 |
| | | Boron nitride | | | | | |
| | | Clay | | | | | |
| | | Kaolin | | | | | |
| | | Aluminum hydroxide | | | | | |
| | | Magnesium hydroxide | | | | | |
| | | Calcium carbonate | | | | | |
| | | Diatom earth | | | | | |
| | Additive | Epoxy silane coupling agent | 1 | 1 | 1 | 1 | 1 |
| | Solvent | Methylethyl ketone | 28 | 28 | 28 | 28 | 28 |
| Amount of polymer (A) (% by weight) *1 | | | 39 | 39 | 39 | 39 | 39 |
| Amount of monomer (B) (% by weight) *1 | | | 22 | 22 | 22 | 22 | 22 |
| Amount of curing agent (C) (% by weight) *1 | | | 22 | 22 | 22 | 22 | 22 |
| Amount of first inorganic filler (D) (% by volume) *2 | | | 45 | 45 | 45 | 45 | 45 |
| Amount of substance (E) (% by volume) *2 | | | 3.8 | 3.8 | 3.8 | 3.8 | 3.8 |
| Left-hand value of the formula (X) | | | 5.41 | 5.41 | 5.41 | 5.41 | 5.41 |
| Evaluation | Handleability | | ○ | ○ | ○ | ○ | ○ |
| | Thermal conductivity (W/m•K) | | 2.2 | 2.1 | 2.4 | 2.3 | 2.4 |
| | Dielectric breakdown voltage (kV/mm) | | 86 | 76 | 88 | 80 | 84 |
| | Solder heat resistance (288°C) | | ◎ | ◎ | ◎ | ◎ | ◎ |
| | Processability | | ◎ | ◎ | ◎ | ◎ | ◎ |
| | Protrusion amount in laminating press | | ○ | ○ | ○ | ○ | ○ |
| | Glass transition temperature (°C) | | -3 | -6 | 4 | 6 | 4 |
| | Self supportability | | ○ | ○ | ○ | ○ | ○ |
| | Heat dissipation capability | | ◎ | ◎ | ◎ | ◎ | ◎ |
| | Bending modulus of uncured insulating sheet at 25°C (MPa) | | 50 | 40 | 60 | 80 | 70 |
| | Bending modulus of cured product of insulating sheet at 25°C (MPa) | | 10000 | 8000 | 11000 | 12000 | 11000 |
| | tan$\delta$ of uncured insulating sheet at 25°C | | 0.8 | 0.8 | 0.6 | 0.5 | 0.5 |
| | Maximum tan$\delta$ of uncured insulating sheet at 25 to 250°C | | 1.7 | 1.8 | 1.6 | 1.9 | 1.7 |
| | Reaction ratio (%) | | 6 | 4 | 8 | 10 | 10 |

*1 The amount in 100% by weight of all the resin components, except for the organic filler (E1), in the insulating sheet
*2 The amount in 100% by volume of the insulating sheet including the organic filler (E1)

[Table 11]

| | | | Comp. Examples | | | |
|---|---|---|---|---|---|---|
| | | | 6 | 7 | 8 | 9 |
| Components (parts by weight) | Polymer (A) | Bisphenol A phenoxy resin | 3 | 15 | 8 | 7 |
| | | Highly heat-resistant phenoxy resin | | | | |
| | | Epoxy group-containing styrene resin | | | | |
| | Polymer other than polymer (A) | Epoxy group-containing acrylic resin | | | | |
| | Epoxy monomer (B1) | Bisphenol A liquid epoxy resin | 2 | 8 | 5 | 3 |
| | | Bisphenol F liquid epoxy resin | | | | |
| | | Trifunctional glycidyl diamine liquid epoxy resin | | | | |
| | | Fluorene skeleton epoxy resin | | | | |
| | | Naphthalene skeleton liquid epoxy resin | | | | |
| | Oxetane monomer (B2) | Benzene-skeleton containing oxetane resin | | | | |
| | Monomer other than monomers (B) | Hexahydrophthalate skeleton liquid epoxy resin | | 5 | 2 | |
| | | Bisphenol A solid epoxy resin | | | | |
| | Curing agent (C) | Alicyclic skeleton acid anhydride | 1 | 6 | 3.5 | 3 |
| | | Aromatic skeleton acid anhydride | | | | |
| | | Polyalicyclic skeleton acid anhydride | | | | |
| | | Terpene skeleton acid anhydride | | | | |
| | | Biphenyl skeleton phenol resin | | | | |
| | | Allyl skeleton phenol resin | | | | |
| | | Triazine skeleton phenol resin | | | | |
| | | Melamine skeleton phenol resin | | | | |
| | | Isocyanurate-modified solid dispersed imidazole | 1 | 2 | 1 | 1 |
| | First inorganic filler (D) | Spherical alumina | | | | |
| | | 2-µm crushed alumina | 61 | 31 | 51 | 23 |
| | | Synthetic magnesite | | | | |
| | | Aluminum nitride | | | | |
| | | Crystalline silica | | | | |
| | | Silicon carbide | | | | |
| | | Zinc oxide | | | | |
| | | Magnesium oxide | | | | |
| | Organic filler (E1) | 0.1-µm particles | | | | |
| | | 0.5-µm particles | | | | |
| | | 4-µm particles | | | | |
| | Second inorganic filler (E2) | Mica | | | | |
| | | Talc | 3 | 3 | 0.5 | 34 |
| | | Boron nitride | | | | |
| | | Clay | | | | |
| | | Kaolin | | | | |
| | | Aluminum hydroxide | | | | |
| | | Magnesium hydroxide | | | | |
| | | Calcium carbonate | | | | |
| | | Diatom earth | | | | |
| | Dispersant (G) | Acrylic dispersant | | | | |
| | | Polyether dispersant | | | | |
| | Additive | Epoxy silane coupling agent | 1 | 2 | 1 | 1 |
| | Solvent | Methylethyl ketone | 28 | 28 | 28 | 28 |
| Amount of polymer (A) (% by weight) *1 | | | 38 | 39 | 39 | 47 |
| Amount of monomer (B) (% by weight) *1 | | | 25 | 21 | 24 | 20 |
| Amount of curing agent (C) (% by weight) *1 | | | 25 | 21 | 22 | 27 |
| Amount of first inorganic filler (D) (% by volume) *2 | | | 67 | 19.5 | 43 | 19 |
| Amount of substance (E) (% by volume) *2 | | | 4.7 | 2.7 | 0.6 | 40.6 |
| Left-hand value of the formula (X) | | | 8.1 | 2.4 | 5.2 | 2.7 |
| Evaluation | Handleability | | ○ | × | ○ | × |
| | Thermal conductivity (W/m•K) | | 2.6 | 0.4 | 1.7 | 0.5 |
| | Dielectric breakdown voltage (kV/mm) | | 68 | 92 | 72 | 28 |
| | Solder heat resistance (288℃) | | ◎ | △ | ◎ | × |
| | Processability | | × | ◎ | ◎ | ◎ |
| | Protrusion amount in laminating press | | ○ | × | × | ○ |
| | Glass transition temperature (℃) | | 9 | 6 | 6 | 8 |
| | Self supportability | | ○ | × | △ | ○ |
| | Heat dissipation capability | | ◎ | × | ◎ | × |
| | Bending modulus of uncured insulating sheet at 25℃ (MPa) | | 300 | 8 | 30 | 450 |
| | Bending modulus of cured product of insulating sheet at 25℃ (MPa) | | 26000 | 3000 | 7000 | 40000 |
| | tanδ of uncured insulating sheet at 25℃ | | 0.2 | 2 | 1.1 | 0.08 |
| | Maximum tanδ of uncured insulating sheet at 25 to 250℃ | | 1.2 | 4.2 | 3 | 0.8 |
| | Reaction ratio (%) | | 8 | 6 | 8 | 6 |

*1 The amount in 100% by weight of all the resin components, except for the organic filler (E1), in the insulating sheet
*2 The amount in 100% by volume of the insulating sheet including the organic filler (E1)

[Table 12]

| | | | Comp. Examples | | | |
|---|---|---|---|---|---|---|
| | | | 10 | 11 | 12 | 13 |
| Components (parts by weight) | Polymer (A) | Bisphenol A phenoxy resin | 5 | 13 | | |
| | | Highly heat-resistant phenoxy resin | | | | |
| | | Epoxy group-containing styrene resin | | | | |
| | Polymer other than polymer (A) | Epoxy group-containing acrylic resin | | | 7 | |
| | Epoxy monomer (B1) | Bisphenol A liquid epoxy resin | 4 | | 4 | 8 |
| | | Bisphenol F liquid epoxy resin | | | | |
| | | Trifunctional glycidyl diamine liquid epoxy resin | | | | |
| | | Fluorene skeleton epoxy resin | | | | |
| | | Naphthalene skeleton liquid epoxy resin | | | | |
| | Oxetane monomer (B2) | Benzene-skeleton containing oxetane resin | | | | |
| | Monomer other than monomers (B) | Hexahydrophthalate skeleton liquid epoxy resin | 2 | | 2 | 3 |
| | | Bisphenol A solid epoxy resin | | | | |
| | Curing agent (C) | Alicyclic skeleton acid anhydride | 3 | 3 | 3 | 5 |
| | | Aromatic skeleton acid anhydride | | | | |
| | | Polyalicyclic skeleton acid anhydride | | | | |
| | | Terpene skeleton acid anhydride | | | | |
| | | Biphenyl skeleton phenol resin | | | | |
| | | Allyl skeleton phenol resin | | | | |
| | | Triazine skeleton phenol resin | | | | |
| | | Melamine skeleton phenol resin | | | | |
| | | Isocyanurate-modified solid dispersed imidazole | 1 | 1 | 1 | 1 |
| | First inorganic filler (D) | Spherical alumina | | | | |
| | | 2-μm crushed alumina | 51 | 51 | 51 | 51 |
| | | Synthetic magnesite | | | | |
| | | Aluminum nitride | | | | |
| | | Crystalline silica | | | | |
| | | Silicon carbide | 5 | | | |
| | | Zinc oxide | | | | |
| | | Magnesium oxide | | | | |
| | Organic filler (E1) | 0.1-μm particles | | | | |
| | | 0.5-μm particles | | | | |
| | | 4-μm particles | | | | |
| | Second inorganic filler (E2) | Mica | | | | |
| | | Talc | | 3 | 3 | 3 |
| | | Boron nitride | | | | |
| | | Clay | | | | |
| | | Kaolin | | | | |
| | | Aluminum hydroxide | | | | |
| | | Magnesium hydroxide | | | | |
| | | Calcium carbonate | | | | |
| | | Diatom earth | | | | |
| | Dispersant (G) | Acrylic dispersant | | | | |
| | | Polyether dispersant | | | | |
| | Additive | Epoxy silane coupling agent | 1 | 1 | 1 | 1 |
| | Solvent | Methylethyl ketone | 28 | 28 | 28 | 28 |
| Amount of polymer (A) (% by weight) *1 | | | 31 | 72 | 0 | 0 |
| Amount of monomer (B) (% by weight) *1 | | | 25 | 0 | 22 | 44 |
| Amount of curing agent (C) (% by weight) *1 | | | 25 | 22 | 22 | 33 |
| Amount of first inorganic filler (D) (% by volume) *2 | | | 47 | 45 | 45 | 45 |
| Amount of substance (E) (% by volume) *2 | | | 5.7 | 3.8 | 3.8 | 3.8 |
| Left-hand value of the formula (X) | | | 6.3 | 5.4 | 5.4 | 5.4 |
| Evaluation | Handleability | | ○ | × | × | × |
| | Thermal conductivity (W/m•K) | | 2.6 | 1.9 | - | - |
| | Dielectric breakdown voltage (kV/mm) | | 70 | 64 | - | - |
| | Solder heat resistance (288℃) | | ◎ | ○ | - | - |
| | Processability | | △ | ◎ | - | - |
| | Protrusion amount in laminating press | | ○ | ○ | - | - |
| | Glass transition temperature (℃) | | 8 | 32 | 3 | -10 |
| | Self supportability | | ○ | ○ | × | × |
| | Heat dissipation capability | | ○ | × | - | - |
| | Bending modulus of uncured insulating sheet at 25℃ (MPa) | | 150 | 1200 | - | - |
| | Bending modulus of cured product of insulating sheet at 25℃ (MPa) | | 18000 | 48000 | - | - |
| | $\tan\delta$ of uncured insulating sheet at 25℃ | | 0.3 | 0.05 | - | - |
| | Maximum $\tan\delta$ of uncured insulating sheet at 25 to 250℃ | | 1.3 | 0.5 | - | - |
| | Reaction ratio (%) | | 7 | 52 | - | - |

*1 The amount in 100% by weight of all the resin components, except for the organic filler (E1), in the insulating sheet

*2 The amount in 100% by volume of the insulating sheet including the organic filler (E1)

## Claims

1. An insulating sheet used for bonding a heat conductor having a thermal conductivity of 10 W/m·K or higher to an electrically conductive layer, comprising:

   (A) a polymer having a weight average molecular weight of 10,000 or more;
   (B) at least one of an epoxy monomer (B1) having an aromatic skeleton and a weight average molecular weight of 600 or less and an oxetane monomer (B2) having an aromatic skeleton and a weight average molecular weight of 600 or less;
   (C) a curing agent; and
   (D) a first inorganic filler; and
   (E) at least one of an organic filler (E1), and a second inorganic filler (E2) that is different from the first inorganic filler (D) and has a new Mohs' hardness of 3 or less,
   wherein
   an amount of the first inorganic filler (D) is 20 to 60% by volume, and
   an amount of the filler (E) is 1 to 40% by volume and, when the filler (E) contains the organic filler (E1), an amount of the organic filler (E1) is 3 to 40% by volume.

2. The insulating sheet according to claim 1, wherein
   the filler (E) is the organic filler (E1) and an amount of the organic filler (E1) is 3 to 40% by volume.

3. The insulating sheet according to claim 1 or 2, wherein
   the first inorganic filler (D) has a thermal conductivity of 10 W/m·K and a new Mohs' hardness of 3.1 or higher.

4. The insulating sheet according to claim 1 or 3, wherein
   the filler (E) is the second inorganic filler (E2) and an amount of the second inorganic filler (E2) is 1 to 40 % by volume.

5. The insulating sheet according to claim 4, wherein
   the first inorganic filler (D) and the second inorganic filler (E2) satisfy a following formula (X):

   [{(New Mohs' hardness of first inorganic filler (D)) × (Amount (% by volume) of first inorganic filler (D) in 100% by volume of insulating sheet)} + {(New Mohs' hardness of second inorganic filler (E2)) × (Amount (% by volume) of second inorganic filler (E2) in 100% by volume of insulating sheet)}] < 6 … (X)

6. The insulating sheet according to any one of claims 1, 3, 4, and 5,
   wherein
   the second inorganic filler (E2) is at least one substance selected from the group consisting of diatom earth, boron nitride, aluminum hydroxide, magnesium hydroxide, calcium carbonate, talc, kaolin, clay, and mica.

7. The insulating sheet according to any one of claims 1 to 3,
   wherein
   the organic filler (E1) has a core-shell structure.

8. The insulating sheet according to any one of claims 1 to 3, and 7,
   wherein
   the organic filler (E1) is a composite filler comprising an organic substance and a compound having a skeleton in which an oxygen atom is directly bonded to a silicon atom.

**9.** The insulating sheet according to any one of claims 1 to 8, wherein the first inorganic filler (D) is at least one substance selected from the group consisting of alumina, synthetic magnesite, crystalline silica, aluminum nitride, silicon nitride, silicon carbide, zinc oxide, and magnesium oxide.

**10.** The insulating sheet according to any one of claims 1 to 9, wherein the polymer (A) has an aromatic skeleton and a weight average molecular weight of 30,000 or more.

**11.** The insulating sheet according to any one of claims 1 to 10, wherein the polymer (A) is a phenoxy resin.

**12.** The insulating sheet according to claim 11, wherein the phenoxy resin has a glass transition temperature Tg of 95°C or higher.

**13.** The insulating sheet according to any one of claims 1 to 12, wherein the curing agent (C) is a phenol resin, or an acid anhydride having an aromatic skeleton or an alicyclic skeleton, a hydrogenated product of the acid anhydride, or a modified product of the acid anhydride.

**14.** The insulating sheet according to claim 13, wherein the curing agent (C) is a first acid anhydride having a polyalicyclic skeleton, a hydrogenated product of the first acid anhydride, or a modified product of the first acid anhydride, or a second acid anhydride having an alicyclic skeleton formed by addition reaction between a terpene compound and maleic anhydride, a hydrogenated product of the second acid anhydride, or a modified product of the second acid anhydride.

**15.** The insulating sheet according to claim 14, wherein the curing agent (C) is an acid anhydride represented by any one of formulas (1) to (3):

[Chem. 1]

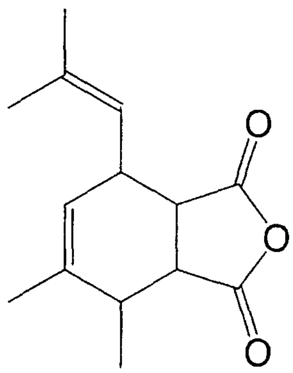

... Formula (1)

[Chem. 2]

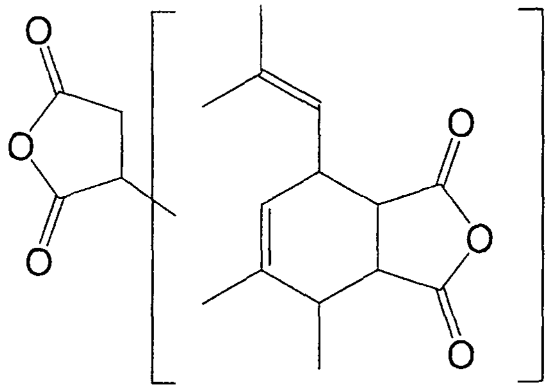

... Formula (2)

[Chem. 3]

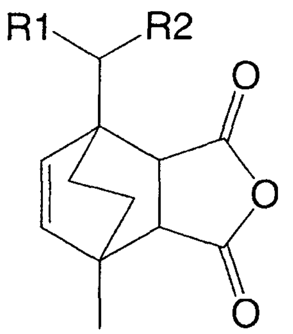

... Formula (3)

wherein R1 and R2 each represent hydrogen, a C1-C5 alkyl group, or a hydroxy group.

**16.** The insulating sheet according to claim 13, wherein the curing agent (C) is a phenol resin having a melamine skeleton or a triazine skeleton, or a phenol resin having an allyl group.

**17.** A laminated structure, comprising:

a heat conductor having a thermal conductivity of 10 W/m·K or higher;
an insulating layer laminated on at least one side of the heat conductor; and
an electrically conductive layer laminated on the insulating layer on the other side of the insulating sheet, wherein
the insulating layer is formed by curing the insulating sheet according to any one of claims 1 to 16.

**18.** The laminated structure according to claim 17, wherein the heat conductor is made of a metal.

[FIG. 1]

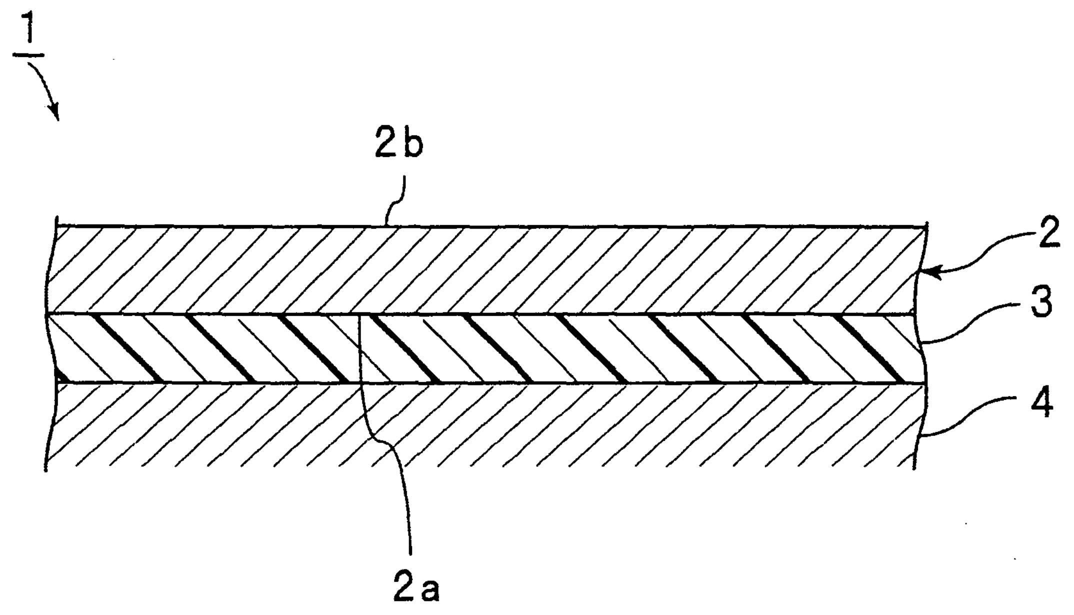

**INTERNATIONAL SEARCH REPORT**

International application No.
PCT/JP2009/054069

A. CLASSIFICATION OF SUBJECT MATTER
*C09J7/02*(2006.01)i, *B32B27/38*(2006.01)i, *C09J11/04*(2006.01)i, *C09J11/08*(2006.01)i, *C09J163/00*(2006.01)i, *C09J171/10*(2006.01)i, *H01B3/00*(2006.01)i

According to International Patent Classification (IPC) or to both national classification and IPC

B. FIELDS SEARCHED

Minimum documentation searched (classification system followed by classification symbols)
C09J1/00-201/10, B32B1/00-35/00, H01B3/00-3/56

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 10-237410 A (Hitachi Chemical Co., Ltd.), 08 September, 1998 (08.09.98), Claims; Par. Nos. [0009], [0024] to [0026] (Family: none) | 1-18 |
| A | JP 59-108072 A (Nitto Electric Industrial Co., Ltd.), 22 June, 1984 (22.06.84), Claims; page 3, lower left column, lines 4 to 11 (Family: none) | 1-18 |
| A | JP 2006-104300 A (KYOCERA Chemical Corp.), 20 April, 2006 (20.04.06), Claims; Par. No. [0012] (Family: none) | 1-18 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 04 June, 2009 (04.06.09) | 16 June, 2009 (16.06.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.
PCT/JP2009/054069

C (Continuation). DOCUMENTS CONSIDERED TO BE RELEVANT

| Category* | Citation of document, with indication, where appropriate, of the relevant passages | Relevant to claim No. |
|---|---|---|
| A | JP 2004-231808 A (Nagase Chemtex Corp.), 19 August, 2004 (19.08.04), Claims; Par. Nos. [0018] to [0022] (Family: none) | 1-18 |
| A | JP 2001-49220 A (Nippon Steel Chemical Co., Ltd.), 20 February, 2001 (20.02.01), Claims; Par. No. [0010] (Family: none) | 1-18 |

Form PCT/ISA/210 (continuation of second sheet) (April 2007)

**INTERNATIONAL SEARCH REPORT**

International application No.
PCT/JP2009/054069

Claim 1 relates to "an insulating sheet for use in bonding of a thermal conductor having a thermal conductivity of not less than 10 W/m·K to an electroconductive layer" and specifies each component of a polymer (A) constituting the insulating sheet, a monomer (B), a curing agent (C), a first inorganic filler (D), and a filler (E) in the claim. Among the above components, the polymer (A) includes all of polymers having a weight average molecular weight of not less than 10,000.

In the description, however, most of polymers concretely stated as working examples for the polymer (A) constituting the insulating sheet are an epoxy group-containing polymer. Examples 66 to 68 state an example where the polymer (A) is an epoxy group-free polymer. In these examples, however, an epoxy group-containing acrylic resin is contained as other polymer. As the whole insulating sheet, the epoxy group-containing polymer is always contained. The insulating sheet further comprises a monomer (B) and a curing agent (C). Accordingly, the disclosure of the description is limited to an insulating sheet obtained by reacting the epoxy group-containing polymer-reactive monomer (B) and the curing agent (C). Consequently, it cannot be simply said that the description states a polymer (A) having a weight average molecular weight of not less than 10,000.

Thus, claim 1 and claims 2 to 18 referring to claim 1 are inadequately supported by the disclosure of the description within the meaning of PCT Article 6.

For the reason set out above, a search has been made on the assumption that the polymer (A) is an epoxy group-containing polymer concretely stated as the working example in the description.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006342238 A
- JP H08332696 A